# EUROPEAN PATENT APPLICATION

(11) **EP 4 738 603 A1**
(43) Date of publication of application: **06.05.2026**
(21) Application number: 25212924.2
(22) Date of filing: 03.11.2025
(51) Int. Cl.: H01Q 1/24, H01Q 9/42, H01Q 5/335, H01Q 5/35, H01Q 5/357

(54) **ANTENNA ASSEMBLY AND ELECTRONIC DEVICE**

(30) Priority: 05.11.2024 CN 202411570831
(71) Applicant: GUANGDONG OPPO MOBILE TELECOMMUNICATIONS CORP., LTD., Dongguan, Guangdong 523860 (CN)
(72) Inventor: ZENG, Zhimin, No.18 Haibin Road Wusha,Chang'an Dongguan,Guangdon, 523860 (CN); PAN, Jin, No.18 Haibin Road Wusha,Chang'an Dongguan,Guangdon, 523860 (CN); TANG, Haijun, No.18 Haibin Road Wusha,Chang'an Dongguan,Guangdon, 523860 (CN)
(74) Representative: Penza, Giancarlo

(57) **Abstract**

The disclosure provides an antenna assembly and an electronic device. The antenna assembly includes a first radiator and a first feed source. The first radiator includes a first ground terminal, a first feeding point, and a first free terminal arranged in sequence. The first feed source is configured to generate first and second radio frequency signals, and is electrically connected to the first feeding point. When the antenna assembly is in a free state, the first radio frequency signal is adapted to excite the first radiator to support a first frequency band, and the second radio frequency signal is adapted to excite the first radiator to support a second frequency band, frequencies of the second frequency band being lower than frequencies of the first frequency band. When the electronic device to which the antenna assembly is applied is covered with a metal protective case, the second radio frequency signal excites the first radiator to support at least part of the first frequency band. The electronic device to which the antenna assembly provided in the disclosure is applied still has good antenna performance in the first frequency band when covered with a metal protective case.

## Description

### TECHNICAL FIELD

The disclosure relates to the field of communication technologies, and particularly to an antenna assembly and an electronic device.

### BACKGROUND

With the development of technology, electronic devices with communication functions such as mobile phones have become increasingly popular and have more and more powerful functions. Such an electronic device usually includes an antenna assembly to realize the communication function of the electronic device. However, in the related art, when the electronic device is covered with a metal protective case, the performance of the antenna assembly in a target frequency band (such as a GPS L1 frequency band) is greatly attenuated, resulting in poor antenna performance in the target frequency band.

### SUMMARY

Embodiments of the disclosure provide an antenna assembly and an electronic device. The invention is set out in the appended set of claims.

In conclusion, in the antenna assembly provided by the embodiments of the disclosure, the first feed source is configured to generate a first radio frequency signal and a second radio frequency signal, and the first feed source is electrically connected with the first feeding point of the first radiator. Therefore, the first radio frequency signal and the second radio frequency signal all excite the same first radiator, so that the first radiator supports the first frequency band and the second frequency band. Compared with a case where the antenna assembly is in a free state, when an electronic device to which the antenna assembly is applied is covered with a metal protective case, due to the influence of the metal protective case, a frequency band supported by the first radiator under excitation of the second radio frequency signal is shifted relative to the second frequency band. When the electronic device to which the antenna assembly is applied is covered with the metal protective case, the frequency band supported by the first radiator under excitation of the second radio frequency signal is shifted towards a frequency higher than the second frequency band, so that at least part of the frequency band supported by the first radiator under excitation of the second radio frequency signal falls within the range of the first frequency band. Therefore, when the electronic device to which the antenna assembly is applied is covered with a metal protective case, the second radio frequency signal excites the first radiator to support at least part of the first frequency band. In this way, when the electronic device to which the antenna assembly is applied is covered with a metal protective case, the antenna assembly still has a large bandwidth in the first frequency band, and the electronic device to which the antenna assembly is applied still has good antenna performance in the first frequency band when covered with the metal protective case.

### BRIEF DESCRIPTION OF THE DRAWINGS

In order to more clearly illustrate technical solutions of the embodiments of the disclosure, drawings needed in the embodiments will be briefly introduced below. Apparently, the drawings in the following description are only some embodiments of the disclosure. For those of ordinary skill in the art, other drawings can be obtained according to these drawings without creative work.
FIG. 1 schematically illustrates an antenna assembly provided by an embodiment of the disclosure.
FIG. 2 schematically illustrates a resonance current of a first resonance mode of the antenna assembly shown in FIG. 1.
FIG. 3 schematically illustrates a resonance current of a second resonance mode of the antenna assembly shown in FIG. 1.
FIG. 4 schematically illustrates an antenna assembly provided by another embodiment of the disclosure.
FIG. 5 schematically illustrates an antenna assembly provided by yet another embodiment of the disclosure.
FIG. 6 schematically illustrates a resonance current generated when the antenna assembly shown in FIG. 5 supports a third frequency band.
FIG. 7 schematically illustrates a resonance current generated when the antenna assembly shown in FIG. 5 supports a fourth frequency band.
FIG. 8 schematically illustrates a first band-pass circuit of the antenna assembly shown in FIG. 5.
FIG. 9 schematically illustrates an antenna assembly provided by still another embodiment of the disclosure.
FIG. 10 schematically illustrates a second band-pass circuit shown in FIG. 9.
FIG. 11 schematically illustrates an antenna assembly provided by a further embodiment of the disclosure.
FIG. 12 schematically illustrates a first impedance matching circuit of the antenna assembly shown in FIG. 11.
FIG. 13 schematically illustrates an antenna assembly provided by yet a further embodiment of the disclosure.
FIG. 14 is a circuit diagram of partial structure of the antenna assembly shown in FIG. 13.
FIG. 15 schematically illustrates an antenna assembly provided by yet a still further embodiment of the disclosure.
FIG. 16 schematically illustrates resonance currents of a first resonance mode and a second enhancement mode of the antenna assembly shown in FIG. 15.
FIG. 17 schematically illustrates resonance currents of a third resonance mode and a third enhancement mode of the antenna assembly shown in FIG. 15.
FIG. 18 schematically illustrates an antenna assembly provided by another embodiment of the disclosure.
FIG. 19 is a schematic structural diagram of some components in the antenna assembly shown in FIG. 18.
FIG. 20 is a comparison chart illustrating attenuations of an antenna assembly provided by an embodiment of the disclosure in a first frequency band and a second frequency band, generated between a case where the antenna assembly is in a free state and a case where an electronic device to which the antenna assembly is applied is covered with a metal protective case.
FIG. 21 illustrates Smith chart curves of an antenna assembly provided by an embodiment of the disclosure in the first frequency band and the second frequency band, for a case where the antenna assembly is in a free state and a case where an electronic device to which the antenna assembly is applied is covered with a metal protective case.
FIG. 22 illustrates standing wave curves of an antenna assembly provided by an embodiment of the disclosure in the first frequency band and the second frequency band, for a case where the antenna assembly is in a free state and a case where an electronic device to which the antenna assembly is applied is covered with a metal protective case.
FIG. 23 illustrates curves of system radiation efficiency and system total efficiency of an antenna assembly in the related art and an antenna assembly provided by the embodiment of the disclosure in the first frequency band and the second frequency band, for a case where the antenna assembly is in a free state and a case where an electronic device to which the antenna assembly is applied is covered with a metal protective case.
FIG. 24 schematically illustrates a standing wave curve of an antenna assembly provided by an embodiment of the disclosure in the first frequency band and the second frequency band.
FIG. 25 schematically illustrates a standing wave curve of an antenna assembly provided by an embodiment of the disclosure in a third frequency band and a fourth frequency band.
FIG. 26 schematically illustrates currents of a first resonance mode and a second enhancement mode of an antenna assembly provided by an embodiment.
FIG. 27 schematically illustrates resonance currents of a third resonance mode and a third enhancement mode of an antenna assembly provided by an embodiment.
FIG. 28 schematically illustrates an electronic device provided by an embodiment of the disclosure.
FIG. 29 schematically illustrates partial structure of the electronic device shown in FIG. 28.

### DETAILED DESCRIPTION OF PREFERRED EMBODIMENTS

The technical solutions of the disclosure will be clearly and comprehensively described below with reference to the accompanying drawings. Apparently, the described embodiments are only a part of the embodiments of the disclosure, not all embodiments. All other embodiments, obtained by those of ordinary skill in the art based on the embodiments provided in the disclosure without creative work, shall fall within the protection scope of the disclosure.

The phrase "an embodiment" mentioned in the disclosure means that a specific feature, structure or characteristic described in connection with the embodiment may be included in at least one embodiment of the disclosure. The appearance of the phrase in various places of the disclosure does not necessarily refer to a same embodiment, and it does not mean that this embodiment is exclusive with, independent of or alternative to other embodiments. Those skilled in the art may explicitly and implicitly understand that each embodiment described in the disclosure may be combined with other embodiments.

Terms "first" and "second" in the specification and claims of the disclosure and the above drawings are used to distinguish different objects, rather than describing a specific order. In addition, terms "comprise/include" and "have" and any variations thereof are intended to cover non-exclusive inclusion. For example, an assembly or device including one or more components is not limited to the listed one or more components, but optionally includes one or more components not listed but inherent to the product, or one or more components that should be provided based on the described function.

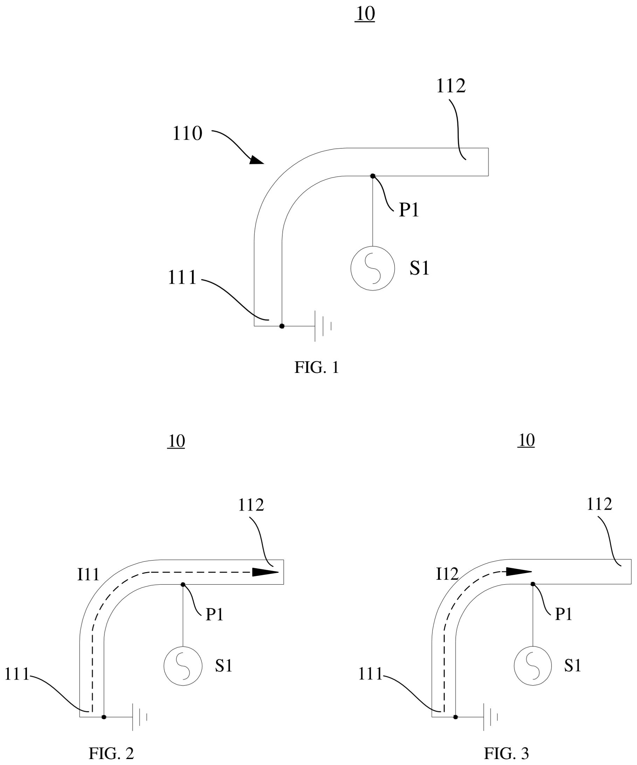

Referring to FIG. 1, a schematic diagram of an antenna assembly provided by an embodiment of the disclosure is illustrated. The antenna assembly 10 includes a first radiator 110 and a first feed source S1. The first radiator 110 includes a first ground terminal 111, a first feeding point P1, and a first free terminal 112 arranged in sequence. The first feed source S1 is used to generate a first radio frequency signal and a second radio frequency signal, and the first feed source S1 is electrically connected with the first feeding point P1. When the antenna assembly 10 is in a free state, the first radio frequency signal is used to excite the first radiator 110 to support a first frequency band, and the second radio frequency signal is used to excite the first radiator 110 to support a second frequency band, the frequencies of the second frequency band being lower than the frequencies of the first frequency band. When an electronic device 1 to which the antenna assembly 10 is applied (i.e., an electronic device 1 has or is provided with the antenna assembly 10) is covered with a metal protective case, the second radio frequency signal excites the first radiator 110 to support at least part of the first frequency band. The free state of the antenna assembly 10 may be a state or a free space condition in which the electronic device 1 to which the antenna assembly 10 is applied is not affected by an external accessory, for example, a state or a free space condition in which the electronic device 1 to which the antenna assembly 10 is applied is not covered with a metal protective case.

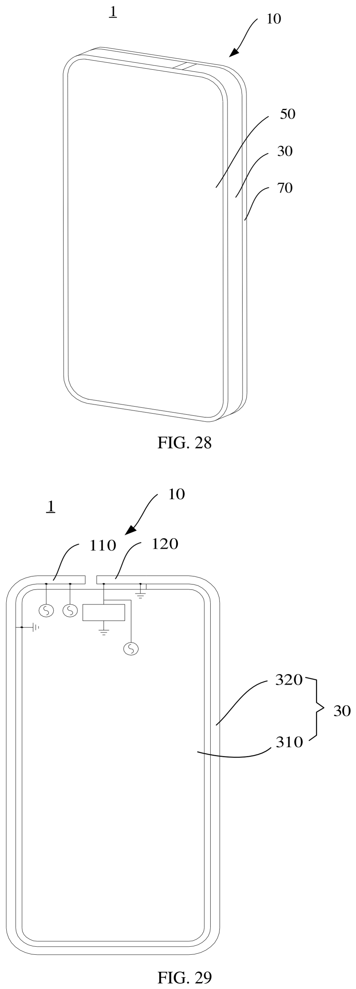

The first radiator 110 may be a Laser Direct Structuring (LDS) radiator, a Flexible Printed Circuit (FPC) radiator, a Print Direct Structuring (PDS) radiator, or a metal stub radiator. When the antenna assembly 10 is applied to the electronic device 1, the first radiator 110 may be a Mechanical Design Antenna (MDA) radiator designed based on the metal insert of the electronic device 1 itself (see FIG. 28 and FIG. 29). For example, the first radiator 110 may be an antenna radiator designed based on a middle frame 30 (see FIG. 28 and FIG. 29) formed by plastic and metal of the electronic device 1. In addition, the first radiator 110 may also be a frame radiator designed based on a metal middle frame 30.

The first ground terminal 111 is electrically connected to a ground electrode. The way of grounding the first ground terminal 111 may include, but is not limited to, electrically connecting it to the ground electrode through a grounding member (such as a conductive elastic sheet, conductive adhesive, a conductive screw, or a connecting rib).

The way of electrically connecting the first feed source S1 with the first feeding point P1 may include, but is not limited to, electrically connecting the first feed source S1 with the first feeding point P1 through a feed member (such as a conductive elastic sheet, conductive adhesive, a conductive screw, or a connecting rib).

The first feed source S1 is used to generate the first radio frequency signal and the second radio frequency signal, and the first feed source S1 is electrically connected with the first feeding point P1 of the first radiator 110. Therefore, the first radio frequency signal and the second radio frequency signal all excite the same radiator (i.e., the first radiator 110), that is, the same radiator (i.e., the first radiator 110) may be shared when the antenna assembly 10 supports the first frequency band and the second frequency band. In some implementations, the first radio frequency signal and the second radio frequency signal may simultaneously excite the first radiator 110 to support the first frequency band and the second frequency band at the same time. In some implementations, the first radiator 110 may support the first frequency band and the second frequency band through for example time division multiplexing. Compared with a case where a separate radiator is used for each frequency band, the first radiator 110 of the antenna assembly 10 provided by the embodiment of the disclosure is small in size, which is beneficial to miniaturization of the antenna assembly 10.

When the antenna assembly 10 is in the free state, the first radio frequency signal is used to excite the first radiator 110 to support the first frequency band which may be, but not limited to, a GPS L1 frequency band. When the antenna assembly 10 is in the free state, the second radio frequency signal is used to excite the first radiator 110 to support the second frequency band which may be, but not limited to, a GPS L5 frequency band. However, the first frequency band and the second frequency band are not limited to the above examples, as long as the frequencies of the second frequency band are lower than the frequencies of the first frequency band.

The so-called metal protective case refers to a protective case containing metal or made of metal. The so-called protective case usually refers to an accessory provided outside the electronic device 1 to protect the electronic device 1. The protective case is not a part of the electronic device 1. The protective case may be sleeved on the electronic device 1, and may also be detached from the electronic device 1.

Compared with the case where the second radio frequency signal excites the first radiator 110 to support the second frequency band when the antenna assembly 10 is in the free state, when the electronic device 1 to which the antenna assembly 10 is applied is covered with a metal protective case, due to influence of the metal protective case, the frequency band supported by the first radiator 110 under excitation of the second radio frequency signal is shifted relative to the second frequency band. For the convenience of description, the frequency band supported by the first radiator 110 under excitation of the second radio frequency signal when the electronic device 1 to which the antenna assembly 10 is applied is covered with a metal protective case is referred to as a first preset frequency band. As can be seen from the above description, the first preset frequency band is different from the second frequency band.

When the electronic device 1 to which the antenna assembly 10 is applied is covered with a metal protective case, the second radio frequency signal excites the first radiator 110 to support at least part of the first frequency band. Specifically, when the electronic device 1 to which the antenna assembly 10 is applied is covered with a metal protective case, the second radio frequency signal excites the first radiator 110 to support the first preset frequency band, and at least part of the first preset frequency band falls within the first frequency band.

Since the frequencies of the second frequency band are lower than the frequencies of the first frequency band, when the electronic device 1 to which the antenna assembly 10 is applied is covered with a metal protective case, the first preset frequency band supported by the first radiator 110 under excitation of the second radio frequency signal is shifted towards a frequency higher than the second frequency band, so that at least part of the first preset frequency band falls within the first frequency band. As can be seen, when the electronic device 1 to which the antenna assembly 10 is applied is covered with a metal protective case, the bandwidth of the first frequency band is increased.

In conclusion, in the antenna assembly 10 provided by the embodiment of the disclosure, the first feed source S1 is used to generate the first radio frequency signal and the second radio frequency signal, and the first feed source S1 is electrically connected with the first feeding point P1 of the first radiator 110. Therefore, the first radio frequency signal and the second radio frequency signal all excite the same first radiator 110, so that the first radiator 110 supports the first frequency band and the second frequency band. Compared with a case where the antenna assembly 10 is in the free state, when the electronic device 1 to which the antenna assembly 10 is applied is covered with a metal protective case, due to influence of the metal protective case, the frequency band supported by the first radiator 110 under excitation of the second radio frequency signal is shifted relative to the second frequency band. When the electronic device 1 to which the antenna assembly 10 is applied is covered with a metal protective case, the frequency band supported by the first radiator 110 under excitation of the second radio frequency signal is shifted towards a frequency higher than the second frequency band, so that at least part of the frequency band supported by the first radiator 110 under excitation of the second radio frequency signal falls within the range of the first frequency band. Therefore, when the electronic device 1 to which the antenna assembly 10 is applied is covered with a metal protective case, the second radio frequency signal excites the first radiator 110 to support at least part of the first frequency band. In this way, when the electronic device 1 to which the antenna assembly 10 is applied is covered with a metal protective case, the antenna assembly 10 still has a large bandwidth in the first frequency band, and the electronic device 1 to which the antenna assembly 10 is applied still has good antenna performance in the first frequency band when covered with the metal protective case.

Referring to FIG. 1 and FIG. 2 together, FIG. 2 schematically illustrates a resonance current of a first resonance mode of the antenna assembly shown in FIG. 1. The first radio frequency signal excites a first resonance mode of the first radiator 110 to support the first frequency band, and the first resonance mode is a quarter-wavelength mode of the first radiator 110.

As can be seen from the structure of the first radiator 110, the first radiator 110 is also referred to as an inverted F radiator (IFA). Therefore, the first resonance mode is also referred to as a quarter-wavelength IFA mode of the first radiator 110.

The resonance mode generated when the first radio frequency signal excites the first radiator 110 to support the first frequency band is referred to as the first resonance mode, and correspondingly, the resonance current of the first resonance mode is referred to as a first resonance current I11.

The first resonance current I11 is distributed between the first ground terminal 111 and the first free terminal 112. In the half-wavelength period shown in the schematic diagram of this embodiment, the first resonance current I11 flows from the first ground terminal 111 to the first free terminal 112. It is understandable that the first resonance current I11 changes periodically, and in a next half-wavelength period, the first resonance current I11 flows from the first free terminal 112 to the first ground terminal 111.

The quarter-wavelength mode is also referred to as the fundamental mode. The first radio frequency signal excites the first resonance mode of the first radiator 110 to support the first frequency band, and the first resonance mode is the quarter-wavelength mode of the first radiator 110. In other words, the fundamental mode of the first radiator 110 supports the first frequency band. When the fundamental mode of the first radiator 110 supports the first frequency band, it has good radiation efficiency.

Referring to FIG. 1 and FIG. 3 together, FIG. 3 schematically illustrates a resonance current of a second resonance mode of the antenna assembly shown in FIG. 1. The second radio frequency signal excites the second resonance mode of the first radiator 110, and the second resonance mode is a composite right/left-handed (CRLH) mode of the first radiator 110.

The resonance mode generated when the second radio frequency signal excites the first radiator 110 to support the second frequency band is referred to as the second resonance mode, and correspondingly, the resonance current of the second resonance mode is referred to as a second resonance current I12.

The second resonance mode is the composite right/left-handed mode of the first radiator 110. In other words, the second resonance mode is an eighth-wavelength mode of the first radiator 110. The second resonance current I12 is mainly distributed between the first ground terminal 111 and the first feeding point P1 of the first radiator 110. The second resonance current I12 is also distributed between the first feeding point P1 and the first free terminal 112 of the first radiator 110, but such distributed current is small.

The second resonance current I12 is distributed between the first ground terminal 111 and the first free terminal 112. The second resonance current I12 is mainly distributed between the first ground terminal 111 and the first feeding point P1 of the first radiator 110. The second resonance current I12 is also distributed between the first feeding point P1 and the first free terminal 112 of the first radiator 110, but such distributed current is small, and the part of the second resonance current I12 distributed between the first feeding point P1 and the first free terminal 112 of the first radiator 110 is not shown. In the half-wavelength period shown in the schematic diagram of this embodiment, the second resonance current I12 flows from the first ground terminal 111 to the first free terminal 112. It is understandable that the second resonance current I12 changes periodically, and in a next half-wavelength period, the second resonance current I12 flows from the first free terminal 112 to the first ground terminal 111.

The antenna assembly 10 provided by the embodiment of the disclosure uses the quarter-wavelength mode of the first radiator 110 to support the first frequency band, and uses the composite right/left-handed mode of the first radiator 110 to support the second frequency band, so that the antenna assembly 10 can support the first frequency band and the second frequency band by multiplexing the same first radiator 110. This enables the antenna assembly 10 to meet the communication requirements at the first frequency band and the second frequency band, achieves the multiplexing of the first radiator 110, and facilitates the miniaturization of the antenna assembly 10.

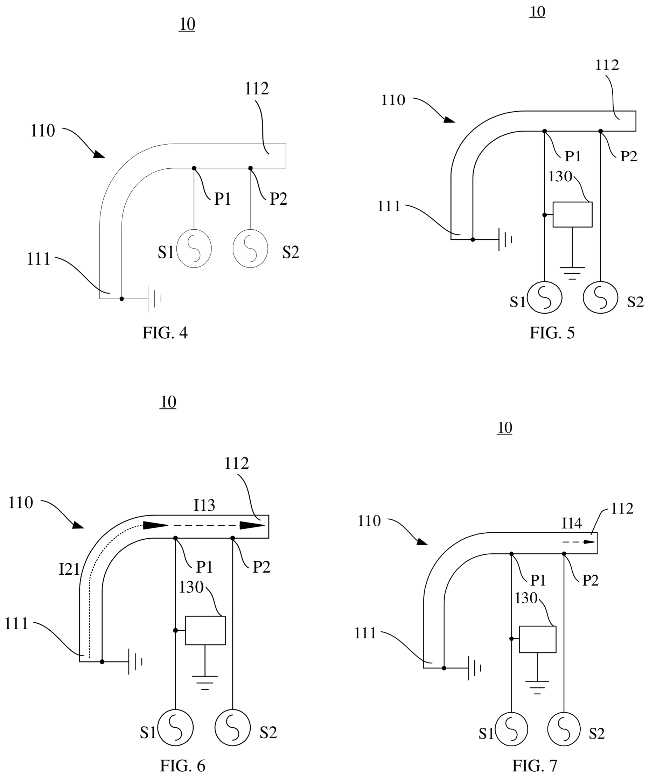

Referring to FIG. 4, a schematic diagram of an antenna assembly provided by another embodiment of the disclosure is illustrated. The antenna assembly 10 includes a first radiator 110 and a first feed source S1. The first radiator 110 includes a first ground terminal 111, a first feeding point P1, and a first free terminal 112 arranged in sequence. The first feed source S1 is used to generate a first radio frequency signal and a second radio frequency signal, and the first feed source S1 is electrically connected with the first feeding point P1. When the antenna assembly 10 is in a free state, the first radio frequency signal is used to excite the first radiator 110 to support a first frequency band, and the second radio frequency signal is used to excite the first radiator 110 to support a second frequency band, where frequencies of the second frequency band are lower than frequencies of the first frequency band. When the electronic device 1 to which the antenna assembly 10 is applied is covered with a metal protective case, the second radio frequency signal excites the first radiator 110 to support at least part of the first frequency band.

For the first feed source S1 and the first radiator 110, reference may be made to the above description, which will not be repeated here.

In addition, in this embodiment, the first radiator 110 further includes a second feeding point P2. The second feeding point P2 is spaced apart from the first feeding point P1, and the second feeding point P2 is closer to the first free terminal 112 than the first feeding point P1.

The antenna assembly 10 further includes a second feed source S2. The second feed source S2 is used to generate a third radio frequency signal and a fourth radio frequency signal. The second feed source S2 is electrically connected with the second feeding point P2. When the antenna assembly 10 is in the free state, the third radio frequency signal excites the first radiator 110 to support a third frequency band, and the fourth radio frequency signal excites the first radiator 110 to support a fourth frequency band. Frequencies of the third frequency band are higher than the frequencies of the first frequency band, and the frequencies of the fourth frequency band are higher than the frequencies of the third frequency band.

The way of electrically connecting the second feed source S2 with the second feeding point P2 may include, but is not limited to, electrically connecting the second feed source S2 with the second feeding point P2 through a feed member (such as a conductive elastic sheet, conductive adhesive, a conductive screw, or a connecting rib).

The second feed source S2 is used to generate the third radio frequency signal and the fourth radio frequency signal, and the second feed source S2 is electrically connected with the second feeding point P2 of the first radiator 110. Therefore, the third radio frequency signal and the fourth radio frequency signal are all applied to the same radiator (i.e., the first radiator 110), so that the same radiator (i.e., the first radiator 110) may be shared when the antenna assembly 10 supports the first frequency band, the second frequency band, the third frequency band, and the fourth frequency band. In some implementations, the first radiator 110 may simultaneously support the first frequency band, the second frequency band, the third frequency band, and the fourth frequency band, through for example multi-mode resonance. In some implementations, the first radiator 110 may support the first frequency band, the second frequency band, the third frequency band, and the fourth frequency band, through for example time division multiplexing. Compared with a case where a separate radiator is used for each frequency band, the first radiator 110 of the antenna assembly 10 provided by the embodiment of the disclosure is small in size, which is beneficial to the miniaturization of the antenna assembly 10.

In addition, the antenna assembly 10 provided by the embodiment of the disclosure can support the first frequency band, the second frequency band, the third frequency band, and the fourth frequency band, and has communication functions in the first frequency band, the second frequency band, the third frequency band, and the fourth frequency band.

When the antenna assembly 10 is in the free state, the third radio frequency signal is used to excite the first radiator 110 to support the third frequency band which may be, but not limited to, a WiFi 2.4 G frequency band. When the antenna assembly 10 is in the free state, the fourth radio frequency signal is used to excite the first radiator 110 to support the fourth frequency band which may be, but not limited to, a N78 frequency band. However, the third frequency band and the fourth frequency band are not limited to the above examples, as long as the frequencies of the fourth frequency band are higher than the frequencies of the third frequency band.

Referring to FIG. 5, a schematic diagram of an antenna assembly provided by yet another embodiment of the disclosure is illustrated. In this embodiment, the antenna assembly 10 includes a first radiator 110, a first feed source S1, and a second feed source S2. For the first radiator 110, the first feed source S1, and the second feed source S2, reference may be made to the above description, which will not be repeated here. In addition, the antenna assembly 10 further includes a first band-pass circuit 130. One terminal of the first band-pass circuit 130 is electrically connected to the first feeding point P1, the other terminal of the first band-pass circuit 130 is grounded, and the first band-pass circuit 130 is a band-pass circuit for the third frequency band.

The antenna assembly 10 further includes the first band-pass circuit 130. One terminal of the first band-pass circuit 130 is electrically connected to the first feeding point P1, the other terminal of the first band-pass circuit 130 is grounded, and the first band-pass circuit is a band-pass circuit for the third frequency band. Therefore, the third radio frequency signal is grounded through the first feeding point P1 and the first band-pass circuit 130. In other words, the first feeding point P1 serves as a point from which the third radio frequency signal of the first radiator 110 supporting the third frequency band is grounded.

Compared with the antenna assembly 10 without the first band-pass circuit 130, the antenna assembly 10 provided by the embodiment of the disclosure further includes the first band-pass circuit 130, so that the antenna assembly 10 has better antenna performance in the third frequency band.

Referring to FIG. 6, it schematically illustrates a resonance current generated when the antenna assembly shown in FIG. 5 supports the third frequency band. The second feed source S2 excites a third resonance mode and a first enhancement mode of the first radiator 110 to support the third frequency band. A resonance current of the third resonance mode (also referred to as a third resonance current I13) is distributed between the first feeding point P1 and the first free terminal 112. A resonance current of the first enhancement mode is distributed between the first ground terminal 111 and the first feeding point P1, and the direction of the resonance current of the first enhancement mode is the same as the direction of the resonance current of the third resonance mode.

The third radio frequency signal excites the third resonance mode of the first radiator 110, and correspondingly, the resonance current of the third resonance mode is referred to as the third resonance current I13.

In a half-wavelength period shown in the schematic diagram of this embodiment, the third resonance current I13 flows from the first feeding point P1 to the first free terminal 112. It may be understood that the third resonance current I13 changes periodically, and in a next half-wavelength period, the third resonance current I13 flows from the first free terminal 112 to the first feeding point P1.

As can be seen from the above description, the first feeding point P1 serves as a point from which the third radio frequency signal of the first radiator 110 supporting the third frequency band is grounded. The third resonance mode is a quarter-wavelength mode of the first radiator 110 between the first feeding point P1 and the first free terminal 112, which is also referred to as a quarter-wavelength IFA mode of the first radiator 110 between the first feeding point P1 and the first free terminal 112.

The third resonance mode is a quarter-wavelength mode of the first radiator 110 between the first feeding point P1 and the first free terminal 112, that is, the fundamental mode of a radiation part of the first radiator 110 between the first feeding point P1 and the first free terminal 112 supports the third frequency band, so that the first radiator 110 has good radiation efficiency when supporting the third frequency band.

For the convenience of description, the resonance current of the first enhancement mode is referred to as a first enhancement current I21. In the current half-wavelength period shown in the schematic diagram of this embodiment, the first enhancement current I21 flows from the first ground terminal 111 to the first feeding point P1. It may be understood that the first enhancement current I21 changes periodically, and in a next half-wavelength period, the first enhancement current I21 flows from the first feeding point P1 to the first ground terminal 111.

It may be understood that the direction of the resonance current of the first enhancement mode (i.e., the first enhancement current I21) is the same as the direction of the resonance current of the third resonance mode (i.e., the third resonance current I13), which means that: when the first enhancement current I21 flows from the first ground terminal 111 to the first feeding point P1, the third resonance current I13 flows from the first feeding point P1 to the first free terminal 112; correspondingly, when the first enhancement current I21 flows from the first feeding point P1 to the first ground terminal 111, the third resonance current I13 flows from the first free terminal 112 to the first feeding point P1.

In other words, in the antenna assembly 10 provided by the embodiment of the disclosure, when supporting the third frequency band, the second feed source S2 not only excites the third resonance current I13 of the first radiator 110, but also excites the first enhancement current I21 in the same direction as the third resonance current I13, so that the antenna assembly 10 has good antenna performance in the third frequency band.

In conclusion, in the antenna assembly 10 provided by the embodiment of the disclosure, the second feed source S2 excites the third resonance mode and the first enhancement mode (also referred to as a first auxiliary mode) of the first radiator 110 to support the third frequency band, and the direction of the resonance current of the first enhancement mode is the same as the direction of the resonance current of the third resonance mode, so that the antenna assembly 10 has good antenna performance in the third frequency band.

Referring to FIG. 7, it schematically illustrates a resonance current generated when the antenna assembly shown in FIG. 5 supports the fourth frequency band. The second feed source S2 of the antenna assembly 10 excites a fourth resonance mode of the first radiator 110 to support the fourth frequency band. A current of the fourth resonance mode is distributed between the second feeding point P2 and the first free terminal 112. The resonance current of the fourth resonance mode is referred to as a fourth resonance current I14. The fourth resonance current I14 is distributed between the second feeding point P2 and the first free terminal 112.

In the half-wavelength period shown in the schematic diagram of this embodiment, the fourth resonance current flows from the second feeding point P2 to the first free terminal 112. It may be understood that the fourth resonance current I14 changes periodically, and in a next half-wavelength period, the fourth resonance current I14 flows from the first free terminal 112 to the second feeding point P2.

In this embodiment, the fourth resonance mode is a quarter-wavelength mode of the first radiator 110 between the second feeding point P2 and the first free terminal 112.

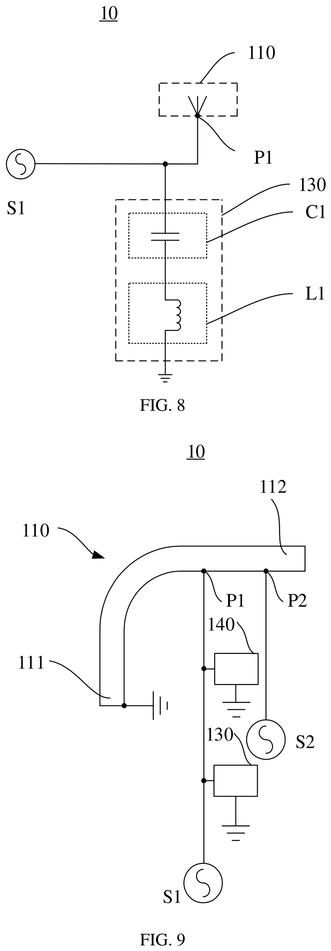

Referring to FIG. 5 and FIG. 8 together, FIG. 8 schematically illustrates the first band-pass circuit of the antenna assembly shown in FIG. 5. In this embodiment, the first band-pass circuit 130 includes a first capacitor C1 and a first inductor L1. One terminal of the first capacitor C1 is electrically connected to the first feeding point P1. One terminal of the first inductor L1 is electrically connected to the other terminal of the first capacitor C1, and the other terminal of the first inductor L1 is grounded.

The first band-pass circuit 130 includes the first capacitor C1 and the first inductor L1. One terminal of the first capacitor C1 is electrically connected to the first feeding point P1. One terminal of the first inductor L1 is electrically connected to the other terminal of the first capacitor C1, and the other terminal of the first inductor L1 is grounded. As can be seen, in the antenna assembly 10 provided by the embodiment of the disclosure, the first band-pass circuit 130 includes the first capacitor C1 and the first inductor L1 connected in series.

For the third frequency band, the third radio frequency signal is grounded through the first feeding point P1, the first capacitor C1, and the first inductor L1. In other words, the first feeding point P1 serves as a point from which the third radio frequency signal of the first radiator 110 supporting the third frequency band is grounded.

Compared with the antenna assembly 10 without the first band-pass circuit 130, the antenna assembly 10 provided by the embodiment of the disclosure further includes the first band-pass circuit 130, so that the antenna assembly 10 has better antenna performance in the third frequency band.

In addition, the first band-pass circuit 130 includes the first capacitor C1 and the first inductor L1, which is simple in structure and easy to implement.

Referring to FIG. 9, it schematically illustrates an antenna assembly provided by still another embodiment of the disclosure. In this embodiment, the antenna assembly 10 includes a first radiator 110, a first feed source S1, a second feed source S2, and a first band-pass circuit 130. For the first radiator 110, the first feed source S1, the second feed source S2, and the first band-pass circuit 130, reference may be made to the above description, which will not be repeated here. Furthermore, in this embodiment, the antenna assembly 10 further includes a second band-pass circuit 140. One terminal of the second band-pass circuit 140 is electrically connected to the first feeding point P1, the other terminal of the second band-pass circuit 140 is grounded, and the second band-pass circuit 140 is a band-pass circuit for the fourth frequency band.

The one terminal of the second band-pass circuit 140 is electrically connected to the first feeding point P1, the other terminal of the second band-pass circuit 140 is grounded, and the second band-pass circuit 140 is a band-pass circuit for the fourth frequency band. Therefore, the fourth radio frequency signal for the fourth frequency band is grounded through the first feeding point P1 and the second band-pass circuit 140. In other words, the first feeding point P1 serves as a point from which the fourth radio frequency signal of the first radiator 110 supporting the fourth frequency band is grounded.

Compared with the antenna assembly 10 without the second band-pass circuit 140, the antenna assembly 10 provided by the embodiment of the disclosure further includes the second band-pass circuit 140, so that the antenna assembly 10 has better antenna performance in the fourth frequency band.

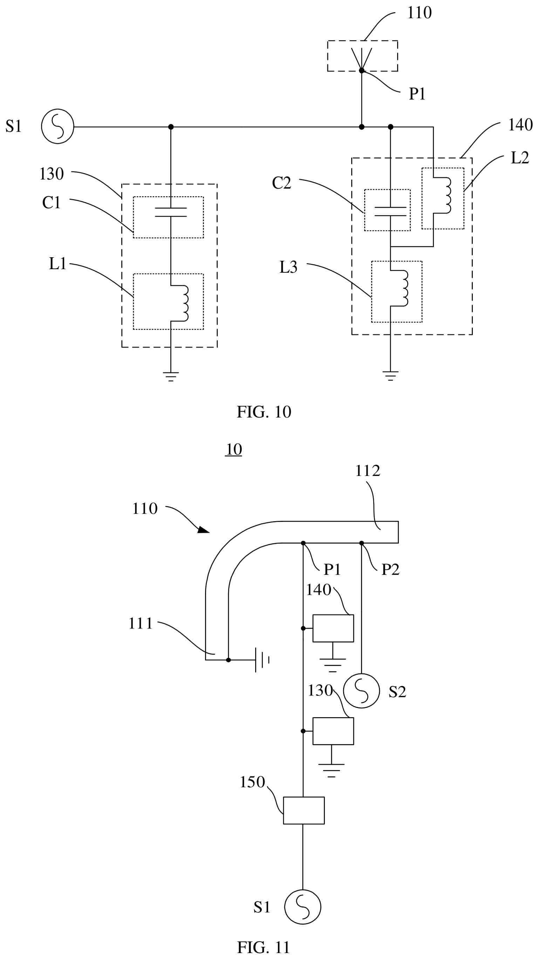

Referring to FIG. 9 and FIG. 10 together, FIG. 10 schematically illustrates the second band-pass circuit shown in FIG. 9. In this embodiment, the second band-pass circuit 140 includes a second capacitor C2, a second inductor L2, and a third inductor L3. One terminal of the second capacitor C2 is electrically connected to the first feeding point P1. The second inductor L2 is connected in parallel with the second capacitor C2. One terminal of the third inductor L3 is electrically connected to the other terminal of the second capacitor C2, and the other terminal of the third inductor L3 is grounded.

Compared with the antenna assembly 10 without the second band-pass circuit 140, the antenna assembly 10 provided by the embodiment of the disclosure further includes the second band-pass circuit 140, so that the antenna assembly 10 has better antenna performance in the fourth frequency band.

In addition, the second band-pass circuit 140 in the antenna assembly 10 provided by the embodiment of the disclosure includes the second capacitor C2, the second inductor L2, and the third inductor L3, which is simple in structure and easy to implement.

Referring to FIG. 11, it schematically illustrates an antenna assembly provided by a further embodiment of the disclosure. In this embodiment, the antenna assembly 10 includes a first radiator 110, a first feed source S1, a second feed source S2, a first band-pass circuit 130, and a second band-pass circuit 140. For the first radiator 110, the first feed source S1, the second feed source S2, the first band-pass circuit 130, and the second band-pass circuit 140, reference may be made to the above description, which will not be repeated here. In this embodiment, the antenna assembly 10 further includes a first impedance matching circuit 150. The first feed source S1 is electrically connected with the first feeding point P1 through the first impedance matching circuit 150, and the first impedance matching circuit 150 is used to perform impedance matching between the first feed source S1 and the first radiator 110.

The antenna assembly 10 further includes the first impedance matching circuit 150, which is used to perform impedance matching between the output impedance of the first feed source S1 and the input impedance of the first radiator 110, so that the first radiator 110 has good antenna performance when supporting the first frequency band, and also has good antenna performance when supporting the second frequency band.

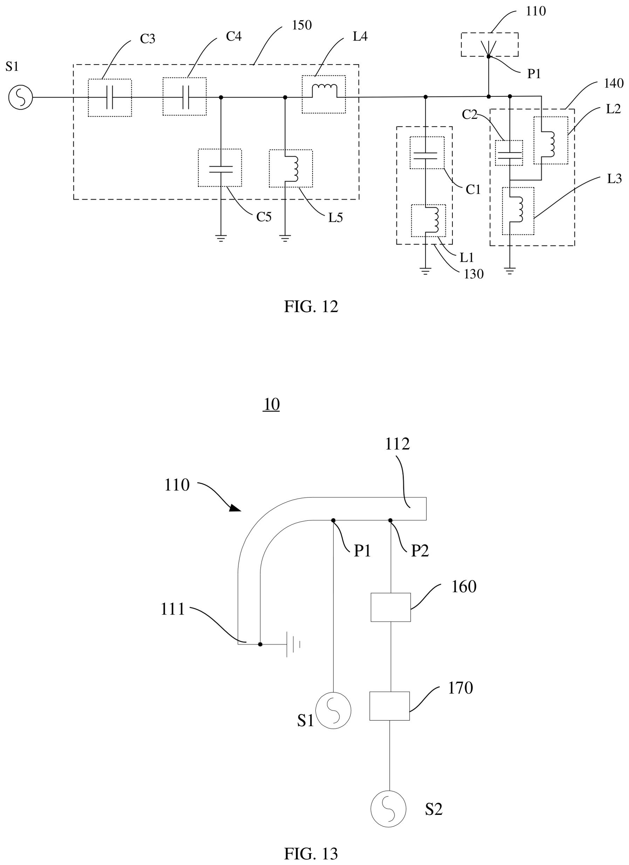

Referring to FIG. 11 and FIG. 12 together, FIG. 12 schematically illustrates the first impedance matching circuit of the antenna assembly shown in FIG. 11. The first impedance matching circuit 150 includes a third capacitor C3, a fourth capacitor C4, a fourth inductor L4, a fifth capacitor C5, and a fifth inductor L5. One terminal of the third capacitor C3 is electrically connected to the first feed source S1. One terminal of the fourth capacitor C4 is electrically connected to the other terminal of the third capacitor C3. One terminal of the fourth inductor L4 is electrically connected to the other terminal of the fourth capacitor C4, and the other terminal of the fourth inductor L4 is electrically connected to the first feeding point P1. One terminal of the fifth capacitor C5 is electrically connected to the one terminal of the fourth inductor L4, and the other terminal of the fifth capacitor C5 is grounded. One terminal of the fifth inductor L5 is electrically connected to the one terminal of the fifth capacitor C5, and the other terminal of the fifth inductor L5 is grounded.

In the antenna assembly 10 provided by the embodiment of the disclosure, the first impedance matching circuit 150 performs impedance matching between the output impedance of the first feed source S1 and the input impedance of the first radiator 110, so that the first radiator 110 has good antenna performance when supporting the first frequency band, and also has good antenna performance when supporting the second frequency band.

In addition, the first impedance matching circuit 150 in the antenna assembly 10 provided by the embodiment of the disclosure is simple in structure and easy to implement.

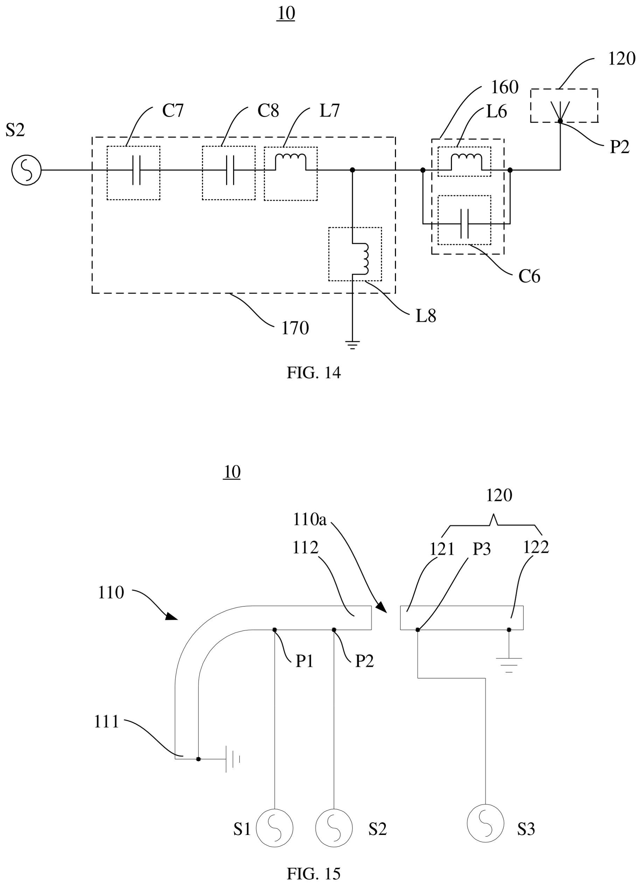

Referring to FIG. 13 and FIG. 14, FIG. 13 is a schematic diagram of an antenna assembly provided by yet a further embodiment of the disclosure, and FIG. 14 is a circuit diagram of partial structure of the antenna assembly shown in FIG. 13. In this embodiment, the antenna assembly 10 further includes a band-stop circuit 160. The second feed source S2 is electrically connected with the second feeding point P2 through the band-stop circuit 160, and the band-stop circuit 160 is a band-stop circuit 160 for the first frequency band.

The band-stop circuit 160 further included in the antenna assembly 10 may be combined with the antenna assembly 10 provided by any of the above embodiments. In the schematic diagram of this embodiment, it is illustrated by taking a case where the band-stop circuit 160 further included in the antenna assembly 10 may be a band-stop circuit 160 capable of being combined with one of the above embodiments as an example, which should not be understood as a limitation to the embodiment of the disclosure.

In this embodiment, the antenna assembly 10 further includes the band-stop circuit 160, which is a band-stop circuit 160 for the first frequency band. Therefore, the second feeding point P2 is open-circuited for the first frequency band. When the second feed source S2 is electrically connected with the second feeding point P2 to excite the first radiator 110 to support the third frequency band and the fourth frequency band, the antenna radiator further includes the band-stop circuit 160, which may prevent the adverse effect of the first frequency band on the antenna performance in the third frequency band, and also prevent the effect of the first frequency band on the antenna performance in the fourth frequency band. Thus, the antenna assembly 10 has good antenna performance in both the third frequency band and the fourth frequency band.

In one embodiment, the band-stop circuit 160 includes a sixth inductor L6 and a sixth capacitor C6. One terminal of the sixth inductor L6 is electrically connected with the second feed source S2, and the other terminal of the sixth inductor L6 is electrically connected to the second feeding point P2. The sixth capacitor C6 is connected in parallel with the sixth inductor L6.

In this embodiment, the band-stop circuit 160 includes the sixth inductor L6 and the sixth capacitor C6, and the sixth inductor L6 and the sixth capacitor C6 together act as a band-stop circuit 160 for the first frequency band. Therefore, it is open-circuited for the first frequency band at the second feeding point P2. When the second feed source S2 is electrically connected with the second feeding point P2 to excite the first radiator 110 to support the third frequency band and the fourth frequency band, the antenna radiator further includes the band-stop circuit 160, which can prevent the adverse effect of the first frequency band on the antenna performance in the third frequency band, and also prevent the effect of the first frequency band on the antenna performance in the fourth frequency band. Thus, the antenna assembly 10 has good antenna performance in both the third frequency band and the fourth frequency band.

In this embodiment, the band-stop circuit 160 includes the sixth inductor L6 and the sixth capacitor C6, which is simple in structure and easy to implement.

Furthermore, referring to FIG. 13 again, the antenna assembly 10 further includes a second impedance matching circuit 170. The second feed source S2 is electrically connected with the second feeding point P2 through the second impedance matching circuit 170 and the band-stop circuit 160 in sequence, and the second impedance matching circuit 170 is configured to perform impedance matching between the second feed source S2 and the first radiator 110.

The antenna assembly 10 further includes the second impedance matching circuit 170, which is used to perform impedance matching between the output impedance of the second feed source S2 and the input impedance of the first radiator 110, so that the first radiator 110 has good antenna performance when supporting the third frequency band, and also has good antenna performance when supporting the fourth frequency band.

Further, referring to FIG. 14, in this embodiment, the second impedance matching circuit 170 includes a seventh capacitor C7, an eighth capacitor C8, a seventh inductor L7, and an eighth inductor L8. One terminal of the seventh capacitor C7 is electrically connected to the second feed source S2. One terminal of the eighth capacitor C8 is electrically connected to the other terminal of the seventh capacitor C7. One terminal of the seventh inductor L7 is electrically connected to the other terminal of the eighth capacitor C8, and the other terminal of the seventh inductor L7 is electrically connected to the band-stop circuit 160. One terminal of the eighth inductor L8 is electrically connected to the other terminal of the seventh inductor L7, and the other terminal of the eighth inductor L8 is grounded.

In this embodiment, the second impedance matching circuit 170 includes the seventh capacitor C7, the eighth capacitor C8, the seventh inductor L7, and the eighth inductor L8, which can well perform impedance matching between the output impedance of the second feed source S2 and the input impedance of the first radiator 110. Thus, the first radiator 110 has good antenna performance when supporting the third frequency band, and also has good antenna performance when supporting the fourth frequency band.

In addition, the second impedance matching circuit 170 includes the seventh capacitor C7, the eighth capacitor C8, the seventh inductor L7, and the eighth inductor L8, which is simple in structure and easy to implement.

Referring to FIG. 15, it schematically illustrates an antenna assembly provided by yet a still further embodiment of the disclosure. In this embodiment, the antenna assembly 10 further includes a second radiator 120 and a third feed source S3. The second radiator 120 and the third feed source S3 further included in the antenna assembly 10 may be combined with the antenna assembly 10 provided by any of the above embodiments. In the schematic diagram of this embodiment, it is illustrated by taking a case where the second radiator 120 and the third feed source S3 further included in the antenna assembly 10 is combined with the antenna assembly 10 provided by one of the above embodiments as an example, which should not be understood as a limitation to the antenna assembly 10 provided by the embodiment of the disclosure.

The second radiator 120 includes a second free terminal 121, a third feeding point P3, and a second ground terminal 122 arranged in sequence. The second free terminal 121 is opposite to the first free terminal 112, and the second free terminal 121 is spaced apart from the first free terminal 112 by a coupling gap 110a. The second radiator 120 is coupled with the first radiator 110 through the coupling gap 110a. The third feed source S3 is used to generate a fifth radio frequency signal, and the third feed source S3 is electrically connected with the third feeding point P3. When the antenna assembly 10 is in the free state, the fifth radio frequency signal excites the second radiator 120 to support a fifth frequency band. The frequencies of the fifth frequency band are higher than the frequencies of the first frequency band. When the electronic device 1 to which the antenna assembly 10 is applied is covered with a metal protective case, the fifth radio frequency signal is used to excite the second radiator 120 to support at least part of the first frequency band.

The second radiator 120 may be a Laser Direct Structuring (LDS) radiator, a Flexible Printed Circuit (FPC) radiator, a Print Direct Structuring (PDS) radiator, or a metal stub radiator. When the antenna assembly 10 is applied to the electronic device 1, the second radiator 120 may be a Mechanical Design Antenna (MDA) radiator designed based on the metal insert of the electronic device 1 itself (see FIG. 28 and FIG. 29). For example, the second radiator 120 may be an antenna radiator designed based on a middle frame 30 (see FIG. 28 and FIG. 29) formed by plastic and metal of the electronic device 1. In addition, the second radiator 120 may also be a frame radiator designed based on the metal middle frame 30. The type of the second radiator 120 may be the same as or different from the type of the first radiator 110.

The second ground terminal 122 is electrically connected to the ground electrode. The way of grounding the second ground terminal 122 may include, but is not limited to, electrically connecting it to the ground electrode through a grounding member (such as a conductive elastic sheet, conductive adhesive, a conductive screw, or a connecting rib).

The way of electrically connecting the third feed source S3 with the third feeding point P3 may include, but is not limited to, electrically connecting the third feed source S3 with the third feeding point P3 through a feed member (such as a conductive elastic sheet, conductive adhesive, a conductive screw, or a connecting rib).

Compared with the case where the fifth radio frequency signal excites the first radiator 110 to support the fifth frequency band when the antenna assembly 10 is in the free state, when the electronic device 1 to which the antenna assembly 10 is applied is covered with a metal protective case, due to influence of the metal protective case, the frequency band supported by the second radiator 120 under excitation of the fifth radio frequency signal is shifted. For the convenience of description, the frequency band supported by the second radiator 120 under excitation of the fifth radio frequency signal when the electronic device 1 to which the antenna assembly 10 is applied is covered with the metal protective case is referred to as a second preset frequency band. As can be seen from the above description, the second preset frequency band is different from the fifth frequency band.

When the electronic device 1 to which the antenna assembly 10 is applied is covered with a metal protective case, the fifth radio frequency signal excites the second radiator 120 to support at least part of the first frequency band. Specifically, when the electronic device 1 to which the antenna assembly 10 is applied is covered with the metal protective case, the fifth radio frequency signal excites the second radiator 120 to support the second preset frequency band, and at least part of the second preset frequency band falls within the first frequency band.

Since the frequencies of the fifth frequency band are higher than the frequencies of the first frequency band, when the electronic device 1 to which the antenna assembly 10 is applied is covered with a metal protective case, the second preset frequency band supported by the second radiator 120 under excitation of the fifth radio frequency signal is shifted towards a frequency lower than the fifth frequency band, so that at least part of the second preset frequency band falls within the first frequency band. As can be seen, when the electronic device 1 to which the antenna assembly 10 is applied is covered with a metal protective case, the bandwidth of the first frequency band is increased.

In conclusion, in the antenna assembly 10 provided by the embodiment of the disclosure, when the electronic device 1 to which the antenna assembly 10 is applied is covered with a metal protective case, the frequency band supported by the second radiator 120 under excitation of the fifth radio frequency signal is shifted towards a frequency band lower than the fifth frequency band, so that at least part of the frequency band supported by the second radiator 120 under excitation of the fifth radio frequency signal falls within the range of the first frequency band. Therefore, when the electronic device 1 to which the antenna assembly 10 is applied is covered with a metal protective case, the fifth radio frequency signal excites the second radiator 120 to support at least part of the first frequency band. In this way, when the electronic device 1 to which the antenna assembly 10 is applied is covered with a metal protective case, the antenna assembly 10 still has a large bandwidth in the first frequency band, and the electronic device 1 to which the antenna assembly 10 is applied still has good antenna performance in the first frequency band when covered with the metal protective case.

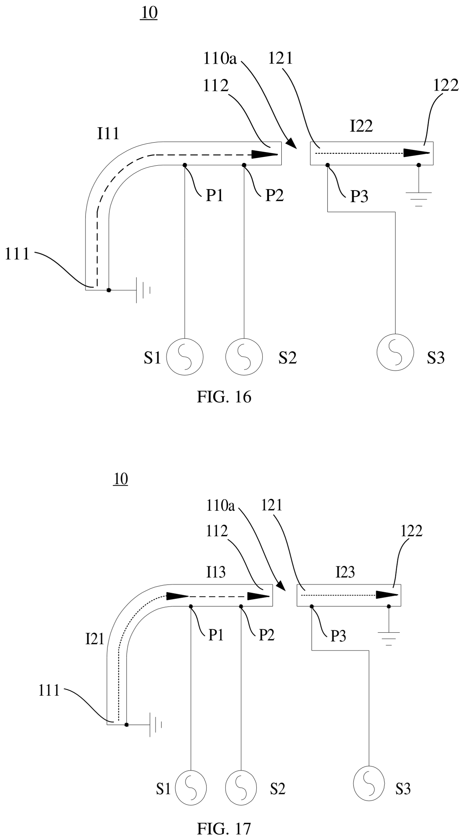

Referring to FIG. 15 and FIG. 16 together, FIG. 16 schematically illustrates resonance currents of a first resonance mode and a second enhancement mode in the antenna assembly shown in FIG. 15. The first feed source S1 is further used to excite a second enhancement mode of the second radiator 120 to support the first frequency band. The resonance current of the second enhancement mode is distributed between the second free terminal 121 and the second ground terminal 122. When the first resonance current I11 in the first resonance mode flows from the first ground terminal 111 to the first free terminal 112, the second enhancement current I22 in the second enhancement mode (also referred to as a second auxiliary mode) flows from the second free terminal 121 to the second ground terminal 122.

In this embodiment, when the antenna assembly 10 further includes the second radiator 120, the first feed source S1 excites the first resonance mode of the first radiator 110 to support the first frequency band. In addition, since the second radiator 120 is coupled with the first radiator 110 through the coupling gap 110a, the first feed source S1 can also excite the second enhancement mode of the second radiator 120 to support the first frequency band. Thus, when the electronic device 1 to which the antenna assembly 10 is applied is covered with a metal protective case, the antenna assembly 10 still has good antenna performance in the first frequency band.

In the current half-wavelength period shown in the schematic diagram of this embodiment, the first resonance current I11 of the first resonance mode flows from the first ground terminal 111 to the first free terminal 112, and correspondingly, the second enhancement current I22 of the second enhancement mode flows from the second free terminal 121 to the second ground terminal 122. It may be understood that both the first resonance current I11 and the second enhancement current I22 change periodically. In a next half-wavelength period, the first resonance current I11 of the first resonance mode flows from the first free terminal 112 to the first ground terminal 111, and correspondingly, the second enhancement current I22 of the second enhancement mode flows from the second ground terminal 122 to the second free terminal 121. The first resonance current I11 and the second enhancement current I22 shown in the schematic diagram of this embodiment should not be understood as a limitation to the antenna assembly 10 provided by the embodiment of the disclosure.

Referring to FIG. 17, it schematically illustrates resonance currents of the third resonance mode and a third enhancement mode in the antenna assembly shown in FIG. 15. When the first radiator 110 has the second feeding point P2 and the antenna assembly 10 further includes the second feed source S2, the second feed source S2 is further used to excite a third enhancement mode (also referred to as a third auxiliary mode) of the second radiator 120 to support the third frequency band. The resonance current of the third enhancement mode is distributed between the second free terminal 121 and the second ground terminal 122, and the direction of the resonance current of the third enhancement mode is the same as the direction of the resonance current of the third resonance mode.

The third radio frequency signal excites the third resonance mode of the first radiator 110, and correspondingly, the resonance current of the third resonance mode is referred to as the third resonance current I13.

In the half-wavelength period shown in the schematic diagram of this embodiment, the third resonance current I13 flows from the first feeding point P1 to the first free terminal 112. It may be understood that the third resonance current I13 changes periodically, and in a next half-wavelength period, the third resonance current I13 flows from the first free terminal 112 to the first feeding point P1.

As can be seen from the above description, the first feeding point P1 serves as a point from which the third radio frequency signal of the first radiator 110 supporting the third frequency band is grounded. The third resonance mode is a quarter-wavelength mode of the first radiator 110 between the first feeding point P1 and the first free terminal 112, which is also referred to as a quarter-wavelength IFA mode of the first radiator 110 between the first feeding point P1 and the first free terminal 112.

The third resonance mode is the quarter-wavelength mode of the first radiator 110 between the first feeding point P1 and the first free terminal 112, that is, the fundamental mode of a radiation part of the first radiator 110 between the first feeding point P1 and the first free terminal 112 supports the third frequency band, so that the first radiator 110 has good radiation efficiency when supporting the third frequency band.

As can be seen from the above description, the third resonance mode supports the third frequency band. Furthermore, in this embodiment, the second feed source S2 is further used to excite the third enhancement mode of the second radiator 120 to support the third frequency band. Thus, the antenna assembly 10 provided by the embodiment of the disclosure has good antenna performance in the third frequency band.

It may be understood that the resonance current of the third resonance mode is referred to as the third resonance current I13, and the resonance current of the third enhancement mode is also referred to as the third enhancement current I23.

The third enhancement current I23 of the third enhancement mode is distributed between the second free terminal 121 and the second ground terminal 122, and the direction of the resonance current (i.e., the third enhancement current I23) of the third enhancement mode is the same as the direction of the resonance current (i.e., the third resonance current I13) of the third resonance mode. Specifically, in the current half-wavelength period shown in the schematic diagram of this embodiment, the third resonance current I13 flows from the first feeding point P1 of the first radiator 110 to the first free terminal 112, and the third enhancement current I23 flows from the second free terminal 121 to the second ground terminal 122. It may be understood that both the third resonance current I13 and the third enhancement current I23 change periodically. In a next half-wavelength period, the third resonance current I13 flows from the first free terminal 112 to the first feeding point P1, and the third enhancement current I23 flows from the second ground terminal 122 to the second free terminal 121.

When the second feed source S2 excites the third resonance mode and the first enhancement mode of the first radiator 110 to support the third frequency band, the third radio frequency signal excites the third resonance mode of the first radiator 110. The resonance current of the first enhancement mode is referred to as the first enhancement current I21. In the current half-wavelength period, the first enhancement current I21 flows from the first ground terminal 111 to the first feeding point P1.

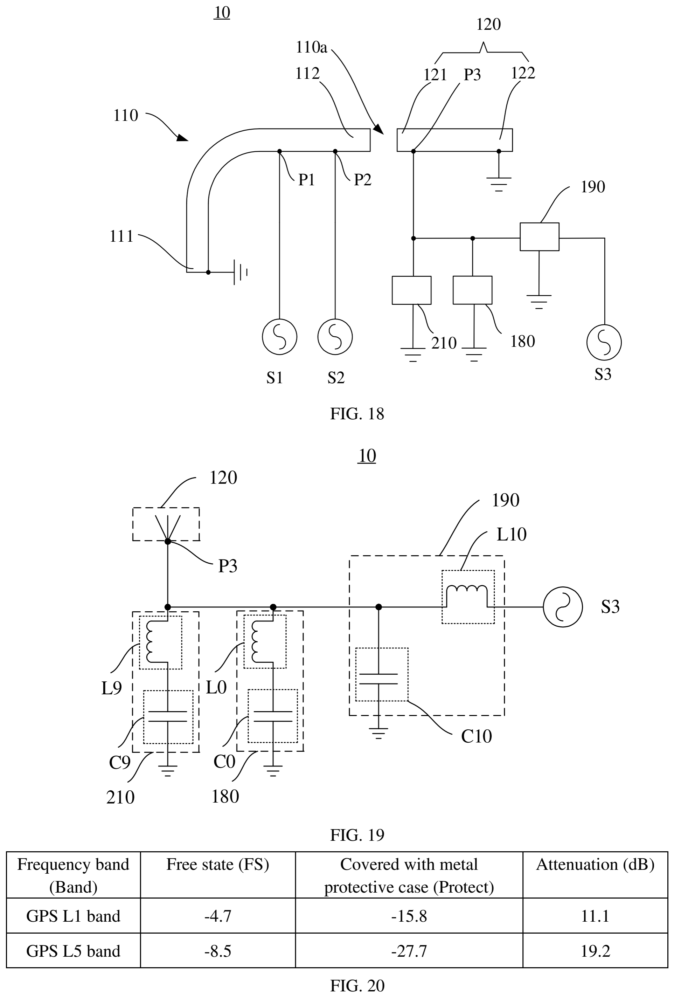

Referring to FIG. 18 and FIG. 19, FIG. 18 schematically illustrates an antenna assembly provided by another embodiment of the disclosure, and FIG. 19 schematically illustrates some components in the antenna assembly shown in FIG. 18. In this embodiment, the antenna assembly 10 further includes an aperture tuning circuit 180. One terminal of the aperture tuning circuit is electrically connected to the third feeding point P3, and the other terminal thereof is grounded. The aperture tuning circuit 180 is used to perform aperture tuning on the fifth frequency band, so that the frequencies of the fifth frequency band are higher than the frequencies of the first frequency band.

In this embodiment, the antenna assembly 10 further includes the aperture tuning circuit 180 which performs aperture tuning on the fifth frequency band, so that the frequencies of the fifth frequency band under excitation of the fifth radio frequency signal are higher than the frequencies of the first frequency band. Therefore, when the electronic device 1 to which the antenna assembly 10 is applied is covered with a metal protective case, the frequency band supported by the second radiator 120 under excitation of the fifth radio frequency signal is shifted relative to the fifth frequency band, so that the fifth radio frequency signal excites the second radiator 120 to support at least part of the first frequency band when the electronic device 1 to which the antenna assembly 10 is applied is covered with a metal protective case. In this way, when the electronic device 1 to which the antenna assembly 10 is applied is covered with a metal protective case, the antenna assembly 10 still has a large bandwidth in the first frequency band, and the electronic device 1 to which the antenna assembly 10 is applied still has good communication effect in the first frequency band when covered with a metal protective case.

Referring to FIG. 19, the aperture tuning circuit 180 includes a tuning inductor L0 and an isolation capacitor C0. One terminal of the tuning inductor L0 is electrically connected to the third feeding point P3. One terminal of the isolation capacitor C0 is electrically connected to the other terminal of the tuning inductor L0, and the other terminal of the isolation capacitor C0 is grounded.

In this embodiment, the aperture tuning circuit 180 includes the tuning inductor L0, and the tuning inductor L0 can well perform aperture tuning on the fifth frequency band, so that the frequencies of the fifth frequency band excited by the fifth radio frequency signal are higher than the frequencies of the first frequency band. Therefore, when the electronic device 1 to which the antenna assembly 10 is applied is covered with a metal protective case, the frequency band supported by the second radiator 120 under excitation of the fifth radio frequency signal is shifted relative to the fifth frequency band, so that the fifth radio frequency signal excites the second radiator 120 to support at least part of the first frequency band when the electronic device 1 to which the antenna assembly 10 is applied is covered with a metal protective case. Thus, when the electronic device 1 to which the antenna assembly 10 is applied is covered with a metal protective case, the antenna assembly 10 still has a large bandwidth in the first frequency band, and the electronic device 1 to which the antenna assembly 10 is applied has a good communication effect in the first frequency band when covered with the metal protective case.

In addition, the aperture tuning circuit 180 further includes the isolation capacitor C0, and the isolation capacitor C0 is used for isolation for the fifth frequency band. Therefore, it is open-circuited for the fifth frequency band at the isolation capacitor C0, so that the performance of the fifth frequency band is not affected.

Further, referring to FIG. 18, the antenna assembly 10 further includes a third band-pass circuit 210. One terminal of the third band-pass circuit 210 is connected to the third feeding point P3, and the other terminal of the third band-pass circuit 210 is grounded. The third band-pass circuit 210 is a band-pass circuit for the third frequency band.

In this embodiment, the antenna assembly 10 further includes the third band-pass circuit 210 which is a band-pass circuit for the third frequency band, and the antenna performance of the antenna assembly 10 in supporting the third frequency band is thereby improved.

Referring to FIG. 19, the third band-pass circuit 210 includes a ninth inductor L9 and a ninth capacitor C9. One terminal of the ninth inductor L9 is connected to the third feeding point P3. One terminal of the ninth capacitor C9 is connected to the other terminal of the ninth inductor L9, and the other terminal of the ninth capacitor C9 is grounded.

In this embodiment, the antenna assembly 10 further includes the third band-pass circuit 210, and the third band-pass circuit 210 includes the ninth inductor L9 and the ninth capacitor C9. One terminal of the ninth inductor L9 is connected to the third feeding point P3, one terminal of the ninth capacitor C9 is connected to the other terminal of the ninth inductor L9, and the other terminal of the ninth capacitor C9 is grounded. This can well improve the antenna performance of the antenna assembly 10 in supporting the third frequency band.

In addition, the third band-pass circuit 210 includes the ninth inductor L9 and the ninth capacitor C9, which is simple in structure and easy to implement.

Furthermore, referring to FIG. 18, the antenna assembly 10 further includes a third impedance matching circuit 190. The third feed source S3 is electrically connected with the third feeding point P3 through the third impedance matching circuit 190, and the third impedance matching circuit 190 is used to perform impedance matching between the third feed source S3 and the second radiator 120.

The antenna assembly 10 further includes the third impedance matching circuit 190, and the third impedance matching circuit 190 is used to perform impedance matching between the output impedance of the third feed source S3 and the input impedance of the second radiator 120, so that the second radiator 120 has good antenna performance in supporting the fifth frequency band.

Further, referring to FIG. 19, in this embodiment, the third impedance matching circuit 190 includes a tenth inductor L10 and a tenth capacitor C10. One terminal of the tenth inductor L10 is electrically connected to the third feed source S3, and the other terminal of the tenth inductor L10 is electrically connected to the third feeding point P3. One terminal of the tenth capacitor C10 is electrically connected to the third feeding point P3, and the other terminal of the tenth capacitor C10 is grounded.

In this embodiment, the third impedance matching circuit 190 includes the tenth inductor L10 and the tenth capacitor C10. One terminal of the tenth inductor L10 is electrically connected to the third feed source S3, the other terminal of the tenth inductor L10 is electrically connected to the third feeding point P3, one terminal of the tenth capacitor C10 is electrically connected to the third feeding point P3, and the other terminal of the tenth capacitor C10 is grounded. Therefore, the tenth inductor L10 and the tenth capacitor C10 can well perform impedance matching between the output impedance of the third feed source S3 and the input impedance of the second radiator 120, so that the second radiator 120 has good antenna performance in the supported fifth frequency band.

In addition, the third impedance matching circuit 190 includes the tenth inductor L10 and the tenth capacitor C10, which is simple in structure and easy to implement.

Next, the performance of the antenna assembly 10 provided by the embodiments of the disclosure is simulated.

Referring to FIG. 20, it illustrates a comparison chart of attenuations of an antenna assembly provided by an embodiment of the disclosure in the first frequency band and the second frequency band, generated between a case where the antenna assembly is in a free state and a case where an electronic device to which the antenna assembly is applied is covered with a metal protective case. In this embodiment, the simulation is carried out by taking a case where the thickness of the metal protective case applied for the antenna assembly 10 is 0.4 mm, the first frequency band is the GPS L1 frequency band, and the second frequency band is the GPS L5 frequency band, as an example. As can be seen from FIG. 20, when the electronic device 1 to which the antenna assembly 10 provided by the embodiment of the disclosure is applied is covered with the metal protective case, the attenuation in the first frequency band is 11.1 dB. In the related art, when the electronic device 1 to which an antenna assembly 10 in the related art is applied is covered with the metal protective case, the attenuation in the first frequency band is about 20 dB compared with the case of being in the free state. As can be seen, when the electronic device 1 to which the antenna assembly 10 provided by the embodiment of the disclosure is applied is covered with the metal protective case, the attenuation in the first frequency band is reduced by about 10 dB. In the case where the first frequency band is the GPS L1 frequency band, the navigation requirements in the GPS L1 frequency band can be met when the electronic device 1 to which the antenna assembly 10 provided by the embodiment of the disclosure is applied is covered with a metal protective case.

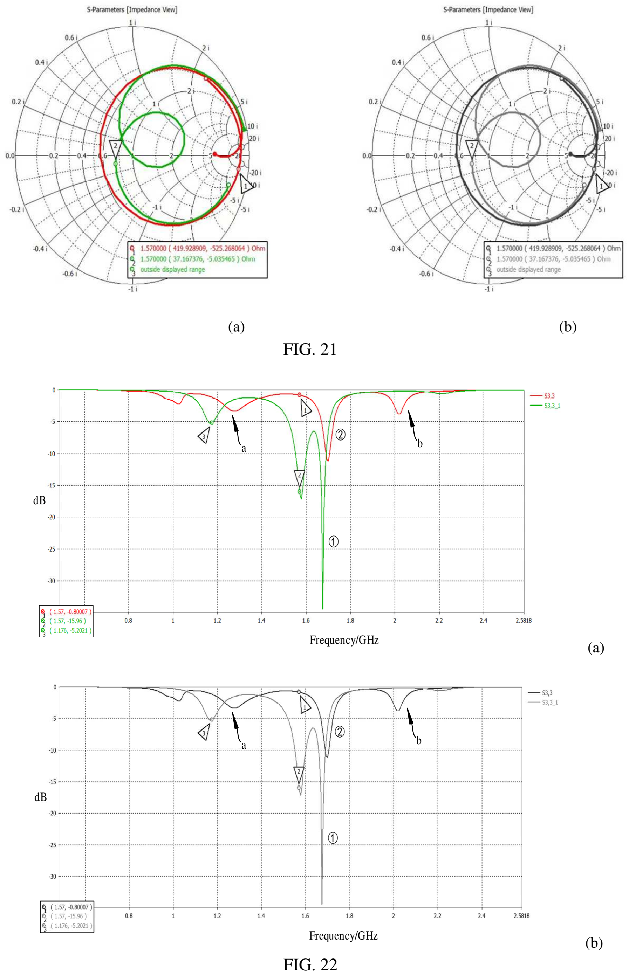

Referring to FIG. 21 and FIG. 22, FIG. 21 illustrates Smith chart curves of an antenna assembly provided by an embodiment of the disclosure in the first frequency band and the second frequency band for a case where the antenna assembly is in a free state and a case where an electronic device to which the antenna assembly is applied is covered with a metal protective case, and FIG. 22 illustrates standing wave curves of the antenna assembly provided by an embodiment of the disclosure in the first frequency band and the second frequency band for a case where the antenna assembly is in a free state and a case where an electronic device to which the antenna assembly is applied is covered with a metal protective case. It is noted that FIG. 21 and FIG. 22 show the same meaning but in different coordinate systems. For the convenience of illustration, (a) in FIG. 21 is a color chart, and (b) in FIG. 21 is a grayscale chart of (a) in FIG. 21. In FIG. 21, the green curve is a curve for the case where the antenna assembly 10 in the free state, and the red curve is a curve for the case where the electronic device 1 to which the antenna assembly 10 is applied is covered with a metal protective case. In FIG. 22, the abscissa represents frequency with the unit of GHz, and the ordinate represents S-Parameter with the unit of dB. For the convenience of illustration, (a) in FIG. 22 is a color chart, and (b) in FIG. 22 is a grayscale chart of (a) in FIG. 22. In FIG. 22, curve ① (see the green curve in FIG. 22) represents the standing wave curve of the antenna assembly 10 in the free state, and curve ② (see the red curve in FIG. 22) represents the standing wave curve of the antenna assembly 10 when the electronic device 1 to which the antenna assembly 10 is applied is covered with a metal protective case. In curve ①, the pit at point 3 represents the second frequency band; and in curve ②, there is also a pit between 1.2 GHz and 1.4 GHz, and the frequency band corresponding to this pit (marked as "a" in the figure) is the frequency band supported by the first radiator 110 under excitation of the second radio frequency signal when the electronic device 1 to which the antenna assembly 10 is applied is covered with a metal protective case. As can be seen, compared with the second frequency band, the frequency band "a" in curve ② is shifted towards a higher frequency, and at least part of the shifted frequency band falls within the range of the first frequency band. As can be seen, when the electronic device 1 to which the antenna assembly 10 is applied is covered with a metal protective case, the second radio frequency signal excites the first radiator 110 to support at least part of the first frequency band; as such, when the electronic device 1 to which the antenna assembly 10 is applied is covered with a metal protective case, the antenna assembly 10 still has a large bandwidth in the first frequency band, and the electronic device 1 to which the antenna assembly 10 is applied still has good antenna performance in the first frequency band when covered with the metal protective case. Furthermore, in curve ② (see the red curve in FIG. 22), there is also a pit between 2.0 GHz and 2.2 GHz, and the frequency band corresponding to the pit (marked as "b" in the figure) is the resonance generated by the second radiator 120 under excitation of the fifth radio frequency signal when the electronic device 1 to which the antenna assembly 10 is applied is covered with a metal protective case, which is shifted towards a lower frequency compared with a pit near 2.2 GHz in curve ①. Therefore, when the electronic device 1 to which the antenna assembly 10 is applied is covered with a metal protective case, the fifth radio frequency signal excites the second radiator 120 to support at least part of the first frequency band; as such, when the electronic device 1 to which the antenna assembly 10 is applied is covered with a metal protective case, the antenna assembly 10 still has a large bandwidth in the first frequency band, and the electronic device 1 to which the antenna assembly 10 is applied still has good antenna performance in the first frequency band when covered with the metal protective case.

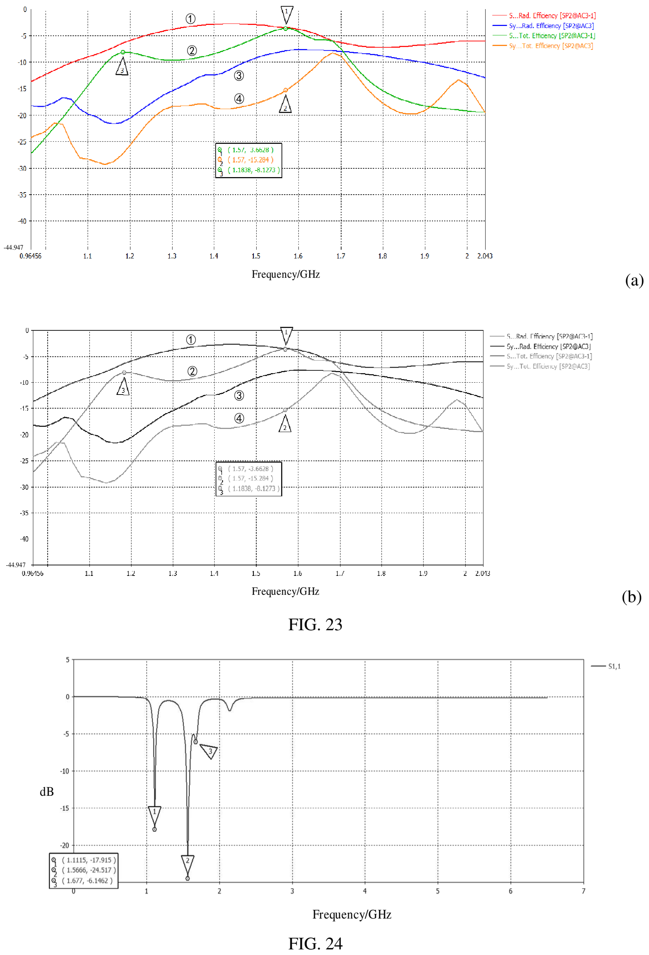

Referring to FIG. 23, it illustrates curves of system radiation efficiency and system total efficiency of an antenna assembly in the related art and an antenna assembly provided by an embodiment of the disclosure in the first frequency band and the second frequency band, for a case where the antenna assembly is in a free state and a case where an electronic device to which the antenna assembly is applied is covered with a metal protective case. In FIG. 23, the abscissa represents frequency with the unit of GHz, and the ordinate represents efficiency with the unit of dB. For the convenience of illustration, (a) in FIG. 23 is a color chart, and (b) in FIG. 23 is a grayscale chart of (a) in FIG. 23. In FIG. 23, curve ① (corresponding to the red curve in (a) of FIG. 23) represents the system radiation efficiency (System Rad. Efficiency) curve of the antenna assembly 10 provided in the related art obtained when it is in a free state; curve ② (corresponding to the green curve in (a) of FIG. 23) represents the system total efficiency (System Tot. Efficiency) curve of the antenna assembly 10 provided in the related art obtained when it is in the free state; curve ③ (corresponding to the blue curve in (a) of FIG. 23) represents the system radiation efficiency (System Rad. Efficiency) curve of the antenna assembly 10 provided in the disclosure obtained when the electronic device 1 to which the antenna assembly 10 is applied is covered with a metal protective case; and curve ④ (corresponding to the orange curve in (a) of FIG. 23) represents the system total efficiency (System Tot. Efficiency) curve of the antenna assembly 10 provided in the disclosure obtained when the electronic device 1 to which the antenna assembly 10 is applied is covered with a metal protective case. As can be seen, when the electronic device 1 to which the antenna assembly 10 provided by the embodiment of the disclosure is applied is covered with a metal protective case, the attenuation in the first frequency band is about 10 dB compared with the related art. In the related art, when covered with a metal protective case, the attenuation of the antenna assembly 10 in the first frequency band is about 20 dB compared with the case of being in free space. Therefore, when the electronic device 1 to which the antenna assembly 10 provided by the embodiments of the disclosure is applied is covered with a metal protective case, small attenuation in the first frequency band is resulted.

Referring to FIG. 24, it schematically illustrates a standing wave curve of an antenna assembly provided by an embodiment of the disclosure in the first frequency band and the second frequency band. In this embodiment, the abscissa represents frequency with the unit of GHz, and the ordinate represents S-Parameter with the unit of dB. As can be seen from this simulation chart, the first frequency band supported by the antenna assembly 10 provided by the embodiment of the disclosure is the GPS L1 frequency band, and the second frequency band supported by the antenna assembly 10 is the GPS L5 frequency band.

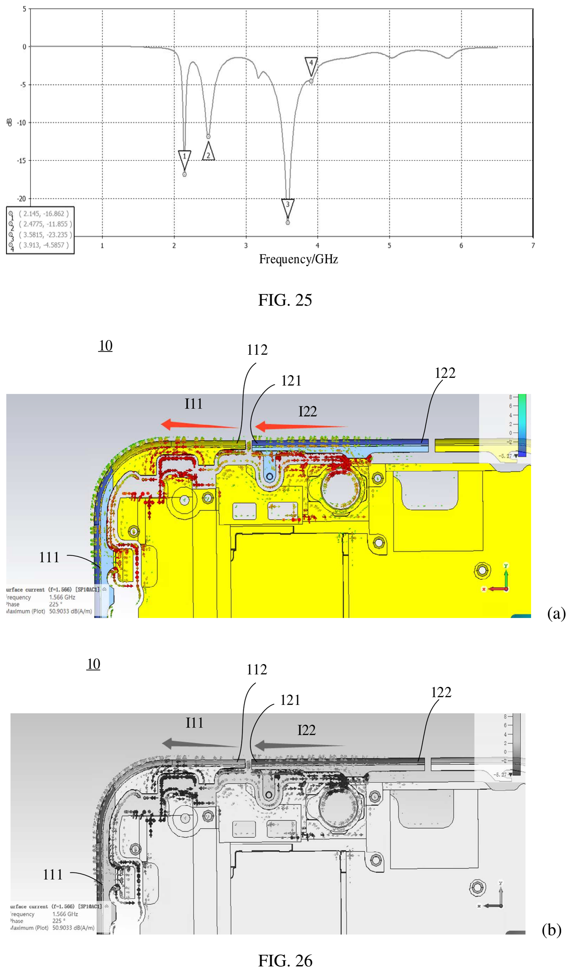

Referring to FIG. 25, it schematically illustrates a standing wave curve of an antenna assembly provided by an embodiment of the disclosure in the third frequency band and the fourth frequency band. In this embodiment, the abscissa represents frequency with the unit of GHz, and the ordinate represents S-Parameter with the unit of dB. As can be seen from this simulation chart, the third frequency band supported by the antenna assembly 10 provided by the embodiment of the disclosure is the WiFi 2.4 frequency band, and the fourth frequency band supported by the antenna assembly 10 is the N78 frequency band.

Referring to FIG. 26, it schematically illustrates currents of the first resonance mode and the second enhancement mode provided by an embodiment. For the convenience of illustration, (a) in FIG. 26 is a color chart, and (b) in FIG. 26 is a grayscale chart of (a) in FIG. 26. As can be seen from this simulation chart, the first resonance current I11 of the first resonance mode flows from the first free terminal 112 to the first ground terminal 111, and the second enhancement current I22 of the second enhancement mode flows from the second ground terminal 122 to the second free terminal 121. The direction of the second enhancement current I22 is the same as the direction of the first resonance current I11.

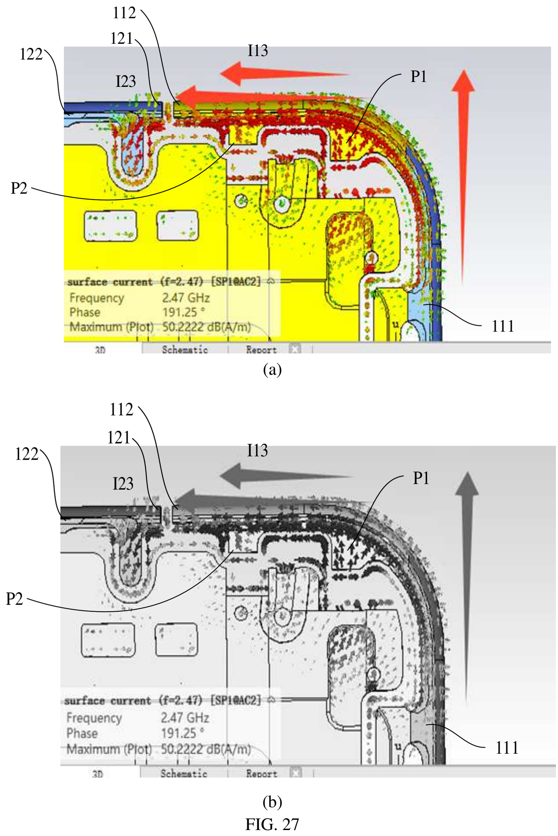

Referring to FIG. 27, it schematically illustrates resonance currents of the third resonance mode and the third enhancement mode of an antenna assembly provided by an embodiment. For the convenience of illustration, (a) in FIG. 27 is a color chart, and (b) in FIG. 27 is a grayscale chart of (a) in FIG. 27. As can be seen from this simulation chart, the third resonance current I13 of the third resonance mode flows from the first feeding point P1 to the first free terminal 112, and the third enhancement current I23 of the third enhancement mode flows from the second free terminal 121 to the second ground terminal 122.

In conclusion, the antenna assembly 10 provided by the embodiments of the disclosure excites the first radio frequency signal and the second radio frequency signal on the same radiator (i.e., the first radiator 110). When the electronic device 1 to which the antenna assembly 10 is applied is covered with a metal protective case, the supported frequency band under excitation of the second radio frequency signal is shifted and thus falls within the range of the first frequency band, thereby increasing the bandwidth of the first frequency band when the electronic device 1 to which the antenna assembly 10 is applied is covered with a metal protective case.

When the first frequency band is the GPS L1 frequency band and the second frequency band is the GPS L5 frequency band, both the first radio frequency signal and the second radio frequency signal are excited on the first radiator 110. When the electronic device 1 to which the antenna assembly 10 is applied is covered with a metal protective case, the GPS L1 frequency band utilizes the radiation capability obtained after the frequency shifting from the GPS L5, thereby increasing the bandwidth of the GPS L1 frequency band when the electronic device 1 to which the antenna assembly 10 is applied is covered with a metal protective case.

In the antenna assembly 10 provided by the embodiments of the disclosure, the first feed source S1 is electrically connected with the first feeding point P1 of the first radiator 110, and the first feed source S1 generates the first radio frequency signal and the second radio frequency signal to excite the first radiator 110 to support the first frequency band and the second frequency band. The second feed source S2 is electrically connected with the second feeding point P2 of the first radiator 110, and the second feed source S2 generates the third radio frequency signal and the fourth radio frequency signal to excite the first radiator 110 to support the third frequency band and the fourth frequency band. Therefore, without increasing the occupied space of the antenna assembly 10, the first radiator 110 can support the first frequency band (such as the GPS L1 frequency band), the second frequency band (such as the GPS L5 frequency band), the third frequency band (such as the WiFi 2.4G frequency band), and the fourth frequency band (such as the N78 frequency band), and the performance of the first radiator 110 in supporting the first frequency band, the second frequency band, the third frequency band, and the fourth frequency band is not deteriorated.

In the antenna assembly 10 provided by the embodiments of the disclosure, the antenna assembly 10 further includes the first band-pass circuit 130. One terminal of the first band-pass circuit 130 is connected to the first feeding point P1, the other terminal of the first band-pass circuit 130 is grounded, and the first band-pass circuit 130 is a band-pass circuit for the third frequency band. The first feeding point P1 serves as a point from which the third radio frequency signal of the first radiator 110 supporting the third frequency band is grounded, thereby realizing wave trapping (WAVETRAP); this can enable the second feed source S2 to excite the first enhancement mode (also referred to as an auxiliary mode) on the first radiator 110 to support the third frequency band, thereby improving the efficiency of the antenna assembly 10 in the third frequency band (such as the WiFi 2.4G frequency band).

In the antenna assembly 10 provided by the embodiments of the disclosure, when the electronic device 1 to which the antenna assembly 10 is applied is covered with a metal protective case, the first resonance mode supports the first frequency band (such as the GPS L1 frequency band), the frequency band supported by the first radiator 110 under excitation of the second radio frequency signal is shifted relative to the second frequency band, and the resonance mode generated by the first radiator 110 under excitation of the second radio frequency signal may also support at least part of the first frequency band. In the case where the antenna assembly 10 further includes the second radiator 120 and the third feed source S3, when the electronic device 1 to which the antenna assembly 10 is applied is covered with a metal protective case, the frequency band supported by the second radiator 120 under excitation of the fifth radio frequency signal is shifted relative to the fifth frequency band, and the resonance mode generated by the second radiator 120 under excitation of the fifth radio frequency signal can support at least part of the first frequency band. In addition, the first feed source S1 is further used to excite the second enhancement mode of the second radiator 120 to support the first frequency band. Therefore, in terms of supporting the first frequency band, the antenna assembly 10 enables multiple resonances supporting the first frequency band, thereby improving the radiation capability of the antenna assembly 10 in the first frequency band when the electronic device 1 to which the antenna assembly 10 is applied is covered with a metal protective case.

In addition, in the antenna assembly 10 provided by the embodiments of the disclosure, the third resonance mode supports the third frequency band (such as the WiFi 2.4G frequency band), and the first enhancement mode also supports the third frequency band. Furthermore, the second feed source S2 is further used to excite the third enhancement mode of the second radiator 120 to support the third frequency band. Therefore, multiple resonance modes of the antenna assembly 10 all support the third frequency band, improving the radiation capability of the antenna assembly 10 in the third frequency band.

An electronic device 1 is further provided by an embodiment of the disclosure. The electronic device 1 includes, but is not limited to, a mobile phone, a telephone, a television, a tablet computer (Pad), a personal computer (PC), a notebook computer, a vehicle-mounted device, an earphone, a watch, a wearable device, and other devices capable of transmitting and receiving electromagnetic wave signals. In the schematic diagram of the embodiment of the disclosure, the electronic device 1 is taken as a mobile phone for illustration, which should not be understood as a limitation to the electronic device 1 provided by the embodiment of the disclosure. Referring to FIG. 28 and FIG. 29, FIG. 28 schematically illustrates an electronic device provided by an embodiment of the disclosure, and FIG. 29 schematically illustrates partial structure of the electronic device shown in FIG. 28. The electronic device 1 includes the antenna assembly 10 mentioned above. For the antenna assembly 10, reference may be made to the above description, which will not be repeated here.

In conclusion, in the antenna assembly 10 of the electronic device 1 provided by the embodiments of the disclosure, the first feed source S1 is used to generate the first radio frequency signal and the second radio frequency signal, and the first feed source S1 is electrically connected with the first feeding point P1 of the first radiator 110. Therefore, the first radio frequency signal and the second radio frequency signal all excite the same first radiator 110, so that the first radiator 110 supports the first frequency band and the second frequency band. Compared with a case where the antenna assembly 10 is in a free state, when the electronic device 1 is covered with a metal protective case, due to influence of the metal protective case, the frequency band supported by the first radiator 110 under excitation of the second radio frequency signal is shifted relative to the second frequency band. When the electronic device 1 is covered with a metal protective case, the frequency band supported by the first radiator 110 under excitation of the second radio frequency signal is shifted towards a frequency higher than the second frequency band, so that at least part of the frequency band supported by the first radiator 110 under excitation of the second radio frequency signal falls within the range of the first frequency band. Therefore, when the electronic device 1 is covered with a metal protective case, the second radio frequency signal excites the first radiator 110 to support at least part of the first frequency band. In this way, when the electronic device 1 is covered with a metal protective case, the antenna assembly 10 still has a large bandwidth in the first frequency band, and the electronic device 1 still has good antenna performance in the first frequency band when covered with a metal protective case.

Furthermore, in an embodiment, the electronic device 1 further includes a middle frame 30. The middle frame 30 includes a frame body 310 and a frame edge portion 320. The frame body 310 serves as the ground electrode in the electronic device 1. The frame edge portion 320 is bent and connected to the periphery of the frame body 310. The first radiator 110 and the second radiator 120 of the antenna assembly 10 are provided at the frame edge portion 320.

Furthermore, in an embodiment, the electronic device 1 further includes a display screen 50 and a battery cover 70. The display screen and the battery cover 70 are respectively disposed on opposite sides of the middle frame 30. It may be understood that the electronic device 1 in the embodiment of the disclosure is only an exemplary application environment of the antenna assembly 10, and it should not be understood as a limitation to the antenna assembly 10 provided by the embodiments of the disclosure.

The foregoing describes some embodiments of the disclosure. It is notable that, for those of ordinary skill in the art, several improvements and modifications can be made without departing from the principle of the disclosure, and such improvements and modifications should also fall within the protection scope of the disclosure.

## Claims

1. An antenna assembly (10), comprising:
a first radiator (110) comprising a first ground terminal (111), a first feeding point (P1), and a first free terminal (112) arranged in sequence; and
a first feed source (S1), configured to generate a first radio frequency signal and a second radio frequency signal, and the first feed source (S1) being electrically connected with the first feeding point (P1);
wherein when the antenna assembly (10) is in a free state, the first radio frequency signal is adapted to excite the first radiator (110) to support a first frequency band, and the second radio frequency signal is adapted to excite the first radiator (110) to support a second frequency band, frequencies of the second frequency band being lower than frequencies of the first frequency band; and
when an electronic device (1) to which the antenna assembly (10) is applied is covered with a metal protective case, the second radio frequency signal is adapted to excite the first radiator (110) to support at least part of the first frequency band.

2. The antenna assembly (10) of claim 1, wherein
the first radio frequency signal is adapted to excite a first resonance mode of the first radiator (110) to support the first frequency band, and the first resonance mode is a quarter-wavelength mode of the first radiator (110); and
the second radio frequency signal is adapted to excite a second resonance mode of the first radiator (110), and the second resonance mode is a composite right/left-handed mode of the first radiator (110).

3. The antenna assembly (10) of any one of claims 1-2, wherein the first radiator (110) further comprises a second feeding point (P2), the second feeding point (P2) is spaced apart from the first feeding point (P1), and the second feeding point (P2) is closer to the first free terminal (112) than the first feeding point (P1);
the antenna assembly (10) further comprises a second feed source (S2), the second feed source (S2) is configured to generate a third radio frequency signal and a fourth radio frequency signal, and the second feed source (S2) is electrically connected with the second feeding point (P2); when the antenna assembly (10) is in the free state, the third radio frequency signal is adapted to excite the first radiator (110) to support a third frequency band, and the fourth radio frequency signal is adapted to excite the first radiator (110) to support a fourth frequency band, frequencies of the third frequency band being higher than the frequencies of the first frequency band, and frequencies of the fourth frequency band being higher than the frequencies of the third frequency band.

4. The antenna assembly (10) of claim 3, further comprising:
a first band-pass circuit (130), wherein one terminal of the first band-pass circuit (130) is electrically connected to the first feeding point (P1), another terminal of the first band-pass circuit (130) is grounded, and the first band-pass circuit (130) is a band-pass circuit for the third frequency band;
wherein the first band-pass circuit (130) comprises:
a first capacitor (C1), one terminal of the first capacitor (C1) being electrically connected to the first feeding point (P1); and
a first inductor (L1), one terminal of the first inductor (L1) being electrically connected to another terminal of the first capacitor (C1), and another terminal of the first inductor (L1) being grounded.

5. The antenna assembly (10) of claim 4, wherein the second feed source (S2) is configured to excite a third resonance mode and a first enhancement mode of the first radiator (110) to support the third frequency band;
wherein a resonance current (I13) of the third resonance mode is distributed between the first feeding point (P1) and the first free terminal (112); and
a resonance current (I21) of the first enhancement mode is distributed between the first ground terminal (111) and the first feeding point (P1), and a direction of the resonance current (I21) of the first enhancement mode is the same as a direction of the resonance current (I13) of the third resonance mode.

6. The antenna assembly (10) of any one of claims 3-5, further comprising:
a second band-pass circuit (140), wherein one terminal of the second band-pass circuit (140) is electrically connected to the first feeding point (P1), another terminal of the second band-pass circuit (140) is grounded, and the second band-pass circuit (140) is a band-pass circuit for the fourth frequency band;
wherein the second band-pass circuit (140) comprises:
a second capacitor (C2), one terminal of the second capacitor (C2) being electrically connected to the first feeding point (P1);
a second inductor (L2) connected in parallel with the second capacitor (C2); and
a third inductor (L3), one terminal of the third inductor (L3) being electrically connected to another terminal of the second capacitor (C2), and another terminal of the third inductor (L3) being grounded.

7. The antenna assembly (10) of any one of claims 1-6, further comprising:
a first impedance matching circuit (150), wherein the first feed source (S1) is electrically connected with the first feeding point (P1) through the first impedance matching circuit (150), and the first impedance matching circuit (150) is configured to perform impedance matching between the first feed source (S1) and the first radiator (110);
wherein the first impedance matching circuit (150) comprises:
a third capacitor (C3), one terminal of the third capacitor (C3) being electrically connected to the first feed source (S1);
a fourth capacitor (C4), one terminal of the fourth capacitor (C4) being electrically connected to another terminal of the third capacitor (C3);
a fourth inductor (L4), one terminal of the fourth inductor (L4) being electrically connected to another terminal of the fourth capacitor (C4), and another terminal of the fourth inductor (L4) being electrically connected to the first feeding point (P1);
a fifth capacitor (C5), one terminal of the fifth capacitor (C5) being electrically connected to the one terminal of the fourth inductor (L4), and another terminal of the fifth capacitor (C5) being grounded; and
a fifth inductor (L5), one terminal of the fifth inductor (L5) is electrically connected to the one terminal of the fourth inductor (L4), and another terminal of the fifth inductor (L5) being grounded.

8. The antenna assembly (10) of any of claims 3-6, wherein the second feed source (S2) is configured to excite a fourth resonance mode of the first radiator (110) to support the fourth frequency band;
wherein a current (I14) of the fourth resonance mode is distributed between the second feeding point (P2) and the first free terminal (112).

9. The antenna assembly (10) of any of claims 3-8, further comprising:
a band-stop circuit (160), wherein the second feed source (S2) is electrically connected with the second feeding point (P2) through the band-stop circuit (160), and the band-stop circuit (160) is a band-stop circuit (160) for the first frequency band;
wherein the band-stop circuit (160) comprises:
a sixth inductor (L6), one terminal of the sixth inductor (L6) being electrically connected with the second feed source (S2), and another terminal of the sixth inductor (L6) being electrically connected to the second feeding point (P2); and
a sixth capacitor (C6) connected in parallel with the sixth inductor (L6).

10. The antenna assembly (10) of claim 9, further comprising:
a second impedance matching circuit (170), wherein the second feed source (S2) is electrically connected with the second feeding point (P2) through the second impedance matching circuit (170) and the band-stop circuit (160) in sequence, and the second impedance matching circuit (170) is configured to perform impedance matching between the second feed source (S2) and the first radiator (110);
wherein the second impedance matching circuit (170) comprises:
a seventh capacitor (C7), one terminal of the seventh capacitor (C7) being electrically connected to the second feed source (S2);
an eighth capacitor (C8), one terminal of the eighth capacitor (C8) being electrically connected to another terminal of the seventh capacitor (C7);
a seventh inductor (L7), one terminal of the seventh inductor (L7) being electrically connected to another terminal of the eighth capacitor (C8), and another terminal of the seventh inductor (L7) being electrically connected to the band-stop circuit (160); and
an eighth inductor (L8), one terminal of the eighth inductor (L8) being electrically connected to the another terminal of the seventh inductor (L7), and another terminal of the eighth inductor (L8) being grounded.

11. The antenna assembly (10) of any one of claims 1-10, further comprising:
a second radiator (120) comprising a second free terminal (121), a third feeding point (P3), and a second ground terminal (122) arranged in sequence, wherein the second free terminal (121) is opposite to the first free terminal (112), the second free terminal (121) is spaced apart from the first free terminal (112) by a coupling gap (110a), and the second radiator (120) is coupled with the first radiator (110) through the coupling gap (110a); and
a third feed source (S3), configured to generate a fifth radio frequency signal, wherein the third feed source (S3) is electrically connected with the third feeding point (P3); when the antenna assembly (10) is in the free state, the fifth radio frequency signal is adapted to excite the second radiator (120) to support a fifth frequency band, frequencies of the fifth frequency band being higher than the frequencies of the first frequency band; and
when the electronic device (1) to which the antenna assembly (10) is applied is covered with the metal protective case, the fifth radio frequency signal is adapted to excite the second radiator (120) to support at least part of the first frequency band.

12. The antenna assembly (10) of claim 11, wherein the first feed source (S1) is further configured to excite a second enhancement mode of the second radiator (120) to support the first frequency band, a resonance current (I22) of the second enhancement mode is distributed between the second free terminal (121) and the second ground terminal (122); and
when the first resonance mode supports the first frequency band and a first resonance current (I11) of the first resonance mode flows from the first ground terminal (111) to the first free terminal (112), a second enhancement current (I22) of the second enhancement mode is adapted to flow from the second free terminal (121) to the second ground terminal (122);
wherein when the first radiator (110) comprises the second feeding point (P2) and the antenna assembly (10) further comprises the second feed source (S2), the second feed source (S2) is further configured to excite a third enhancement mode of the second radiator (120) to support the third frequency band; when the third resonance mode of the first radiator (110) is excited by the second feed source (S2) to support the third frequency band, a resonance current (I23) of the third enhancement mode is distributed between the second free terminal (121) and the second ground terminal (122), and a direction of the resonance current (I23) of the third enhancement mode is the same as a direction of the resonance current (I13) of the third resonance mode.

13. The antenna assembly (10) of any one of claims 11-12, further comprising:
an aperture tuning circuit (180), wherein one terminal of the aperture tuning circuit (180) is electrically connected to the third feeding point (P3), and another terminal of the aperture tuning circuit (180) is grounded; the aperture tuning circuit (180) is configured to perform aperture tuning of the fifth frequency band so that the frequencies of the fifth frequency band are higher than the frequencies of the first frequency band;
wherein the aperture tuning circuit (180) comprises:
a tuning inductor (L0), one terminal of the tuning inductor (L0) being electrically connected to the third feeding point (P3); and
an isolation capacitor (C0), one terminal of the isolation capacitor (C0) being electrically connected to another terminal of the tuning inductor (L0), and another terminal of the isolation capacitor (C0) being grounded.

14. The antenna assembly (10) of any one of claim 11-13, further comprising:
a third band-pass circuit (210), wherein one terminal of the third band-pass circuit (210) is connected to the third feeding point (P3), another terminal of the third band-pass circuit (210) is grounded, and the third band-pass circuit (210) is a band-pass circuit for the third frequency band;
wherein the third band-pass circuit (210) comprises:
a ninth inductor (L9), one terminal of the ninth inductor (L9) being connected to the third feeding point (P3); and
a ninth capacitor (C9), one terminal of the ninth capacitor (C9) being connected to another terminal of the ninth inductor (L9), and another terminal of the ninth capacitor (C9) being grounded;
wherein the antenna assembly (10) further comprises:
a third impedance matching circuit (190), wherein the third feed source (S3) is electrically connected with the third feeding point (P3) through the third impedance matching circuit (190), and the third impedance matching circuit (190) is configured to perform impedance matching between the third feed source (S3) and the second radiator (120);
wherein the third impedance matching circuit (190) comprises:
a tenth inductor (L10), one terminal of the tenth inductor (L10) being electrically connected to the third feed source (S3), and another terminal of the tenth inductor (L10) being electrically connected to the third feeding point (P3); and
a tenth capacitor (C10), one terminal of the tenth capacitor (C10) being electrically connected to the third feeding point (P3), and another terminal of the tenth capacitor (C10) being grounded.

15. An electronic device (1), comprising the antenna assembly (10) of any one of claims 1-14.
